(19) Europäisches Patentamt
European Patent Office
Office européen des brevets

(11) **EP 2 387 085 A1**

(12) **EUROPEAN PATENT APPLICATION**

(43) Date of publication:
**16.11.2011 Bulletin 2011/46**

(51) Int Cl.:
**H01L 51/52** *(2006.01)*

(21) Application number: **11164715.2**

(22) Date of filing: **04.05.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **14.05.2010 JP 2010111609**

(71) Applicant: **Hitachi Ltd.**
**Tokyo (JP)**

(72) Inventors:
• **Konno, Akitoyo**
**Chiyoda-ku**
**Tokyo 100-8220 (JP)**

• **Fujimori, Masaaki**
**Chiyoda-ku**
**Tokyo 100-8220 (JP)**
• **Kaneko, Hiroki**
**Chiyoda-ku**
**Tokyo 100-8220 (JP)**
• **Ishihara, Shingo**
**Chiyoda-ku**
**Tokyo 100-8220 (JP)**

(74) Representative: **Beetz & Partner**
**Patentanwälte**
**Steinsdorfstrasse 10**
**80538 München (DE)**

(54) **Organic light emitting diode and light source device including the same**

(57) An organic light emitting diode has a reflection electrode (102), an organic layer (103) with a luminous point (104), a transparent electrode (105), an output-side substrate (108), and a light scattering layer (109) in contact with the output-side substrate. The light scattering layer is made of a base material and particles (110) contained therein. These particles are higher in refractive index than the base material and the output-side substrate. The luminous point emits light at an emission peak wavelength $\lambda$ (nm). Letting a height from an interface between the electrode and the organic layer to the luminous point be "$a \times d$" (where d (nm) is the thickness of the organic layer, $0 < a < 1$), the height satisfies: $(2m-155/180)\lambda/4/n/\cos 35° \leq a \times d \leq (2m-155/180)\lambda/4/n/\cos 50°$ (where n is the refractive index of the organic layer, and m is an integer larger than or equal to 1).

FIG.1

**Description**

BACKGROUND OF THE INVENTION

The present invention relates to an organic light emitting diode and a light source device using the same.

As one prior art, JP-A-2004-296423 discloses therein a technique which follows. An objective of this prior art is to provide an organic electroluminescence device capable of efficiently extracting loss light which was confined within the device as waveguide light to thereby improve external light extraction efficiency. The prior art relates to an organic electroluminescence device of the type having at least one organic layer, including a light emission layer, and a pair of electrodes consisting essentially of a reflective electrode and a transparent electrode with the organic layer being sandwiched therebetween. These constituents are formed in such a manner that a front-face luminance value of emission light to be irradiated from a light extraction surface toward the observer side and luminance values in those directions of 50 to 70 degrees satisfy the following relationship: front-face luminance value < luminance values in 50-70 degree directions. The device is characterized by providing a region which generates turbulence in reflection and refraction angles of light while the light emitted from the emission layer exits to the observer side through the transparent electrode.

SUMMARY OF THE INVENTION

A problem faced with the prior art device is that the light extraction efficiency is kept low because of the fact that total reflection can take place at interfaces of respective layers constituting an organic light emitting diode. It is therefore an object of the present invention to improve the light extraction efficiency in the organic light emitting diode and a light source device using this diode.

Principal features of this invention for attaining the foregoing object are as follows.

(1) An organic light emitting diode includes an electrode, an organic layer having a luminous point, a transparent electrode, an output-side substrate, and a light scattering layer in contact with the output-side substrate, wherein the electrode, the organic layer, the transparent electrode and the output-side substrate are arranged in this order of sequence toward a direction of taking light out of the organic layer, wherein the light scattering layer is composed of a base material and particles contained therein, wherein the refractive index of the particles is higher than refractive indexes of the base material and the output-side substrate, wherein the luminous point emits light at an emission peak wavelength $\lambda$ (nm), and wherein when the height from an interface between the electrode and the organic layer to the luminous point is given by "a$\times$d" (where d (nm) is the thickness of the organic layer, and 0<a<1), the height satisfies a relational expression which follows: $(2m-155/180)\lambda/4/n/\cos35° \leq a \times d \leq (2m-155/180)\lambda/4/n/\cos50°$ (where n is a refractive index of the organic layer, and m is an integer larger than or equal to 1).

(2) In the organic light emitting diode as recited in the above-noted paragraph (1), the light scattering layer is formed between the output-side substrate and the transparent electrode.

(3) In the organic light emitting diode as recited in the above paragraph (1), the light scattering layer is formed on the opposite side to the existing side of the transparent electrode with respect to the output-side substrate.

(4) In the organic light emitting diode recited in any one of the paragraphs (1) to (3), a first transparent resin layer is disposed between the output-side substrate and the transparent electrode, and the refractive index of the first transparent resin layer is the same as the refractive index of the output-side substrate.

(5) In the organic light emitting diode recited in any one of the paragraphs (1) to (4), the particles include specific particles with a grain size of from 0.5$\mu$m to 6.0$\mu$m, and the average particle pitch of these specific particles ranges from 1.0 time to 6.0 times the grain size of the specific particles.

(6) In the organic light emitting diode recited in any one of the paragraphs (1) to (4), the particles include specific particles with a grain size of from 0.5$\mu$m to 6.0$\mu$m, and the average particle pitch of the specific particles is greater than or equal to the grain size of the specific particles and less than or equal to 12$\mu$m.

(7) In the organic light emitting diode recited in any one of the paragraphs (1) to (4), the particles include special particles with a grain size of 0.5$\mu$m to 2.0$\mu$m, and the average particle pitch of the special particles is 1.0 time to 3.0 times the grain size of the special particles.

(8) In the organic light emitting diode recited in any one of the paragraphs (1) to (4), the particles include special particles with a grain size of 0.5$\mu$m to 2.0$\mu$m, and the average particle pitch of the special particles is larger than or equal to the grain size of the special particles and less than or equal to 4.0$\mu$m.

(9) In the organic light emitting diode recited in any one of the paragraphs (1) to (3) and (5) to (8), a first transparent resin layer is placed between the transparent electrode and the output-side substrate; a first conic solid-like transparent resin is formed within the first transparent resin layer; a bottom face of the first conic solid-like transparent resin is adhered to the output-side substrate; and, the first conic solid-like transparent resin has its expansion from the first transparent resin layer toward the output-side substrate in a normal line direction of the output-side substrate.

(10) In the organic light emitting diode recited in the paragraph (9), the above-stated height "a×d" satisfies: $(2m-155/180)\lambda/4/n/\cos36° \leq a×d \leq (2m-155/180)\lambda 4/n/\cos48°$.

(11) In the organic light emitting diode recited in the paragraph (9) or (10), the refractive index of the first transparent resin layer is more than or equal to 1.7 and less than or equal to 2.0 whereas the refractive index of the first conic solid-like transparent resin is set to more than or equal to 1.5 and less than 1.7.

(12) In the organic light emitting diode recited in any one of the paragraphs (9) to (11), a value of the refractive index of the first transparent resin layer divided by the refractive index of the output-side substrate is more than or equal to 1.13 and less than or equal to 1.33, and a value of the refractive index of the first conic solid-like transparent resin divided by the refractive index of the output-side substrate is more than or equal to 1 and less than 1.13.

(13) In the organic light emitting diode recited in any one of the paragraphs (9) to (12), the refractive index of the first conic solid-like transparent resin is more than or equal to 1.50 and less than or equal to 1.54, and an expansion angle of the first conic solid-like transparent resin is more than or equal to 75° and less than or equal to 85°.

(14) In the organic light emitting diode recited in any one of the paragraphs (9) to (12), the refractive index of the first conic solid-like transparent resin is more than or equal to 1.55 and less than or equal to 1.64, and an expansion angle of the first conic solid-like transparent resin is more than or equal to 70° and less than or equal to 80°.

(15) In the organic light emitting diode recited in any one of the paragraphs (9) to (14), the first conic solid-like transparent resin is disposed in a surface of the output-side substrate in a dense fill manner.

(16) An organic light emitting diode includes an electrode, an organic layer having a luminous point, a transparent electrode, a first transparent resin layer, a first conic solid-like transparent resin formed within the first transparent resin layer, an output-side substrate and a second conic solid-like transparent resin, wherein the electrode, the organic layer, the transparent electrode, the first transparent resin layer, the first conic solid-like transparent resin, the output-side substrate and the second conic solid-like transparent resin are placed in this order of sequence toward a direction of light extraction from the organic layer, wherein bottom faces of the first conic solid-like transparent resin and the second conic solid-like transparent resin are adhered to the output-side substrate, wherein the first conic solid-like transparent resin has expansion from the first transparent resin layer toward the output-side substrate in a normal line direction of the output-side glass substrate, wherein the refractive index of the second conic solid-like transparent resin is the same as the refractive index of the output-side substrate, wherein the second conic solid-like transparent resin has expansion toward the opposite direction to the direction of light extraction from the organic layer in the normal line direction of the output-side substrate, wherein the luminous point emits light at an emission peak wavelength λ (nm), and wherein when the height from an interface between the electrode and the organic layer to the luminous point is given by "a×d" (where d (nm) is the thickness of the organic layer, and 0<a<1), the height satisfies a relational expression which follows: $(2m-155/180)\lambda/4/n/\cos35° \leq a×d \leq (2m-155/180)\lambda/4/n/\cos50°$ (where n is the refractive index of the organic layer, and m is an integer larger than or equal to 1).

(17) In the organic light emitting diode as recited in the paragraph (16), an expansion angle of the second conic solid-like transparent resin in the opposite direction to the direction of light extraction from the organic layer is more than or equal to 45° and less than or equal to 60°.

(18) In the organic light emitting diode recited in the paragraph (16) or (17), the second conic solid-like transparent resin is disposed in a surface of the output-side substrate in a dense fill manner.

(19) An organic light emitting diode includes an electrode, an organic layer having a luminous point, a transparent electrode, a first transparent resin layer, a diffuse reflection layer, a second transparent resin layer and an output-side substrate, wherein the electrode, the organic layer, the transparent electrode, the first transparent resin layer, the diffuse reflection layer, the second transparent resin layer and the output-side substrate are arranged in this order of sequence toward a direction of light extraction from the organic layer, wherein the transparent electrode is formed to have a stripe shape, wherein the diffuse reflection layer is opened at those portions at which the electrode and the transparent electrode overlap each other in a normal line direction of the output-side substrate, wherein the refractive index of the first transparent resin layer is the same as the refractive index of the output-side substrate, wherein the refractive index of the second transparent resin layer is the same as the refractive index of the output-side substrate, wherein the luminous point emits light at an emission peak wavelength λ (nm), and wherein when a height from an interface between the electrode and the organic layer to the luminous point is given by "a×d" (where d (nm) is a thickness of the organic layer, and 0<a<1), the height satisfies a relational expression which follows: $(2m-155/180)\lambda/4/n/\cos35° \leq a×d \leq (2m-155/180)\lambda/4/n/\cos50°$ (where n is the refractive index of the organic layer, and m is an integer larger than or equal to 1).

(20) A light source apparatus includes the organic light emitting diode as recited in any one of the paragraphs (1) through (19), and a drive device which drives the organic light emitting diode.

With this invention, it is possible to an organic light emitting diode with improved light extraction efficiency and light source apparatus using this diode. Other objects, features and advantages of the invention will be apparent from the following more particular description of embodiments.

BRIEF DESCRIPTION OF THE DRAWINGS

Fig. 1 is a diagram showing a perspective view of a device structure in accordance with one embodiment of the present invention.

Fig. 2 shows a cross-sectional view of the structure in one embodiment of this invention.

Fig. 3 is a sectional view for explanation of an interference effect of organic light emitting diode.

Fig. 4 is a graph showing effects in one embodiment of this invention.

Fig. 5 is a sectional diagram showing a principle in one embodiment of this invention.

Fig. 6 shows a cross-sectional view of one embodiment of this invention along with a top plan view of a light scattering layer.

Fig. 7 is a graph showing effects in one embodiment of this invention.

Fig. 8 is a graph showing effects in one embodiment of this invention.

Fig. 9 is a perspective view of a device structure in one embodiment of this invention.

Fig. 10 is a cross-sectional diagram showing a principle in one embodiment of this invention.

Fig. 11 is a cross-sectional diagram showing a principle in one embodiment of this invention.

Fig. 12 is a graph showing effects in one embodiment of this invention.

Fig. 13 is a graph showing effects in one embodiment of this invention.

Fig. 14 is a graph showing effects in one embodiment of this invention.

Fig. 15 is a graph showing effects in one embodiment of this invention.

Fig. 16 is a graph showing effects in one embodiment of this invention.

Fig. 17 is a graph showing effects in one embodiment of this invention.

Fig. 18 is a graph showing effects in one embodiment of this invention.

Fig. 19 is a graph showing effects in one embodiment of this invention.

Fig. 20 is a graph showing effects in one embodiment of this invention.

Fig. 21 is a graph showing effects in one embodiment of this invention.

Fig. 22 is a graph showing effects in one embodiment of this invention.

Fig. 23 is a graph showing effects in one embodiment of this invention.

Fig. 24 is a graph showing effects in one embodiment of this invention.

Fig. 25 is a graph showing effects in one embodiment of this invention.

Fig. 26 is a graph showing effects in one embodiment of this invention.

Fig. 27 is a plan view of a device structure in one embodiment of this invention.

Fig. 28 is a perspective view of a device structure in one embodiment of this invention.

Fig. 29 is a perspective view of a device structure in one embodiment of this invention.

Fig. 30 is a perspective view of a device structure in one embodiment of this invention.

Fig. 31 is a cross-sectional diagram showing a device structure in one embodiment of this invention.

Fig. 32 is a sectional diagram showing a principle in one embodiment of this invention.

Fig. 33 is a graph showing effects in one embodiment of this invention.

Fig. 34 is a perspective view of a device structure in one embodiment of this invention.

Fig. 35 is a sectional view of a device structure in one embodiment of this invention.

Fig. 36 is a sectional diagram showing a principle in one embodiment of the invention.

Fig. 37 depicts a structure of one prior known organic light emitting diode.

Fig. 38 shows another structure of prior art organic light emitting diode.

DETAILED DESCRIPTION OF THE INVENTION

Illustrative embodiments of this invention will now be described with reference to the accompanying figures of the drawing below.

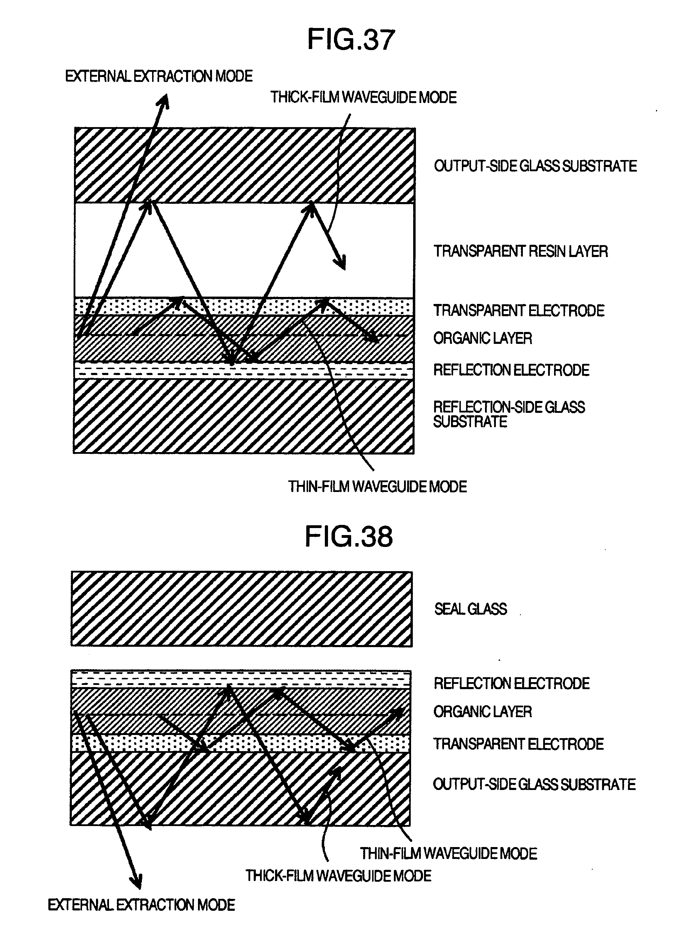

A structure of organic light emitting diode (OLED) shown in Fig. 37 is as follows. An organic layer composed of organic molecules is formed on a reflection electrode which is formed on a reflection-side electrode. On the organic layer, a transparent electrode is formed, which is made of indium oxide with a slight amount of tin added thereto, i.e., indium-tin-oxide (ITO), or indium oxide with a small amount of zinc added thereto, i.e., indium-zinc-oxide (IZO). Further, a transparent resin layer is disposed on the transparent electrode, with an output-side substrate being situated on the transparent resin layer. This structure is generally known as the top emission type. On the other hand, an OLED structure shown in Fig. 38 is as follows. A transparent electrode is placed on an output-side substrate. An organic layer is formed on the transparent electrode. A reflection electrode is formed on the organic layer. On the reflection electrode, a sealing glass plate for use as a reflection-side substrate is disposed above the reflection electrode with a vacuum or an inactive gas-filled layer being situated between the electrode and the glass plate. This structure is commonly called the bottom emission type. Both the top emission type and the bottom emission type are arranged to illuminate an exterior space by causing the light that was produced within the organic layer to go out of the output-side substrate.

The reflection electrode is typically made of aluminum. For example, in a case where the reflection electrode is used as the cathode, a layer called the electron transportation layer is formed on the reflection electrode; a hole transport layer is formed on the transparent electrode side. A layer called the light emission layer or emissive layer is formed between the electron transport layer and the hole transport layer. Electrons and holes are recombined together in a region of about 10 nanometers (nm) in close proximity to either an interface between the emissive layer and electron transport layer or an interface between the emissive layer and hole transport layer; thus, the organic layer emits light. Which one of the hole transport layer side interface and the electron transport layer side interface of the emissive layer contributes to the light emission is arbitrarily designed depending on the carrier mobility of material or the like on a case-by-case basis. In the description of this invention, the interface at which main light emission takes place in the way stated supra will be called the luminous point.

The refractive index of the organic layer is typically about 1.8. The refractive index of the transparent electrode is about 2.0. The refractive index of the transparent resin layer is about 1.5. The refractive index of the output-side substrate is 1.5 or more or less.

The light produced at the luminous point passes through the transparent electrode, transparent resin layer and output-side substrate and then exits to the exterior. However, in the case of the top emission type, reflection occurs at the interface between the transparent electrode and transparent resin layer and at the interface between the transparent resin layer and output-side substrate and also at the interface between the output-side substrate and ambient air; so, the amount of light to be actually taken out to the exterior becomes extremely low. In the case of the bottom emission type, reflection occurs at the interface between the transparent electrode and output-side substrate and the interface between the output-side substrate and air so that the amount of light to be extracted to the outside becomes very low.

Light incapable of being brought out into the output-side substrate due to the influence of total reflection is called the thin-film waveguide mode. Additionally, the light that was emitted at the luminous point is divided into light which goes for the transparent electrode side and light which goes for the transparent electrode side after having once reflected at the reflection electrode. In this case, upon failure to properly control interference conditions of these two kinds of light rays, the thin-film waveguide mode increases undesirably.

Meanwhile, light that is totally reflected at the interface between the output-side substrate and ambient air and thus cannot be extracted into the air will be called the thick-film waveguide mode. Note here that light which was actually brought out or extracted to the air is called the external extraction mode.

Letting the light emitted by the organic layer be 100%, the following relations are given:

thin-film waveguide mode (%) = 100 - efficiency of extraction to output-side substrate,

thick-film waveguide mode (%) = extraction efficiency to output-side electrode - extraction efficiency to air,

external extraction mode (%) = extraction efficiency to air = light extraction efficiency.

Briefly, there is a relation which follows:

light extraction efficiency (%) = 100 - (thinfilm waveguide mode + thickfilm waveguide mode).

In order to enlarge the light extraction efficiency, it is required to reduce both the thin-film waveguide mode and the thick-film waveguide mode, thereby increasing the external extraction mode. Embodiments as will be described later are the ones that have been made to solve the above-stated problem to thereby provide a technique capable of reducing both the thin-film waveguide mode and the thick-film waveguide mode in OLED devices, thus making it possible to obtain highly enhanced light extraction efficiency.

Practical embodiments will be indicated below for more detailed explanation of the contents of the invention of this patent application. Embodiments to be given below are the ones that indicate practical examples of the contents of this invention, which are not to be construed as limiting the invention. Various modifications and alterations may occur to those skilled in the art within the true spirit and scope of the technological idea as set forth in the description. Also note that in all figures of the drawing used to explain such embodiments, those parts or components having the same functionalities are designated by the same reference numerals, and repetitive explanations thereof will be eliminated.

(Embodiment 1)

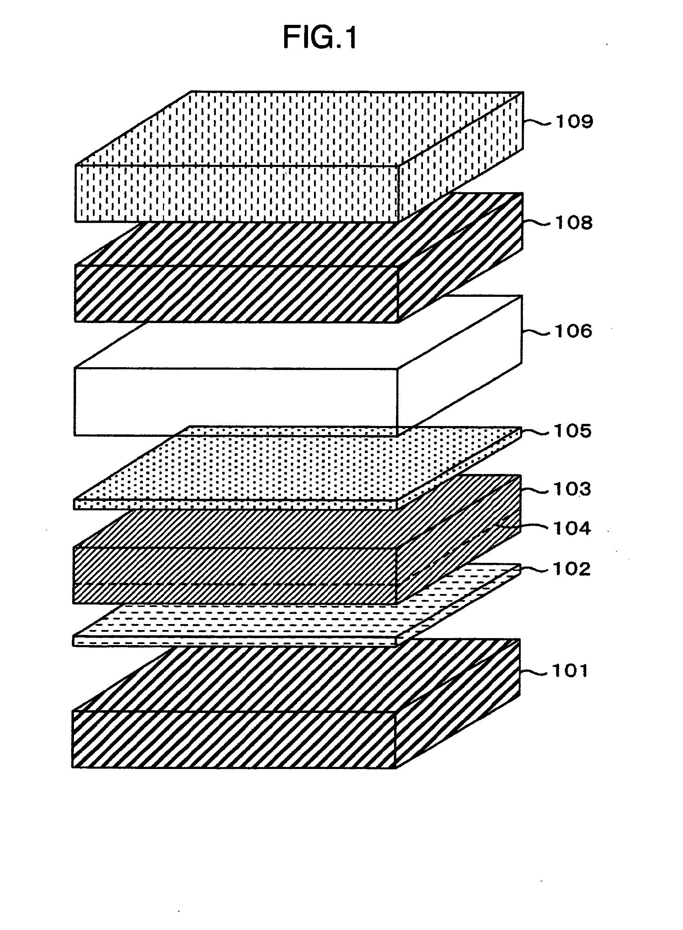

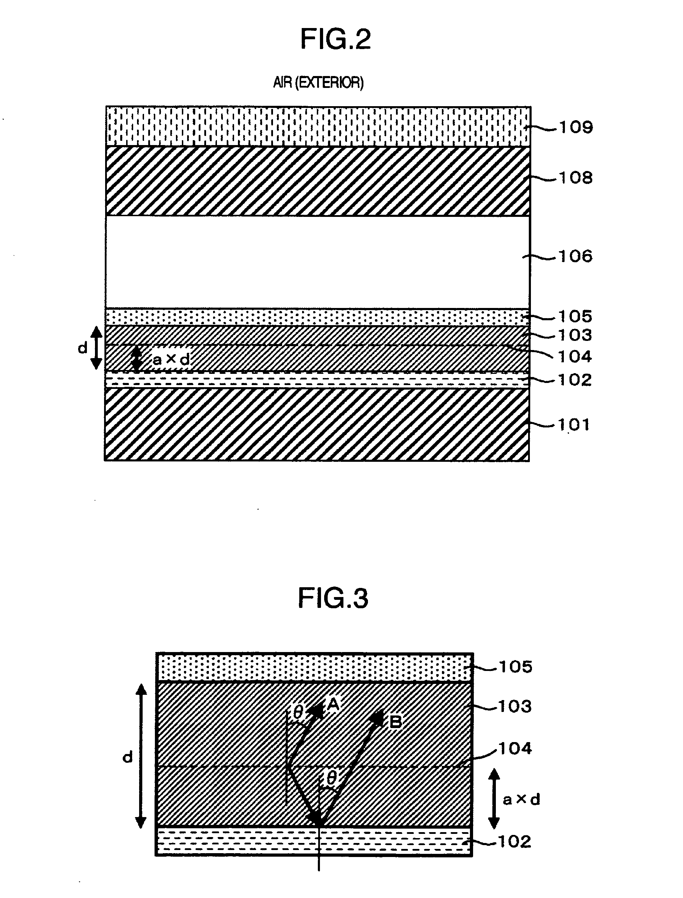

Fig. 1 is a diagram showing an exploded perspective view of an organic light emitting diode (OLED) device in accordance with one embodiment of this invention. Fig. 2 is a diagram showing, in cross-section, a structure of the OLED of this embodiment. The OLED of this embodiment has a reflection-side substrate 101, aluminum reflection electrode 102, organic layer 103, transparent electrode 105 made of indium-tin-oxide (ITO) or indium-zinc-oxide (IZO), first transparent resin layer 106, output-side substrate 108, and light scattering layer 109. A direction in which light travels from the reflection-side substrate 101 toward the output-side substrate 108 is set as the direction of light extraction from the organic layer 103. The reflection-side substrate 101 and output-side substrate 108 may typically be made of glass or plastic substrate materials (such as polychloroprene, polyethylene terephthalate (PET) or the like). In a viewpoint of prevention of contamination of the organic layer, it is desirable that the reflection-side substrate 101 and output-side substrate 108 be made of glass. The reflection electrode 102 is formed on the reflection-side substrate 101. On the reflection electrode 102, the organic layer 103 composed of organic molecules is formed. The organic layer 103 has its refractive index of about 1.8; practically, it is greater than or equal to 1.7 and less than or equal to 1.9. The organic layer 103 involves a luminous point 104. From this luminous point 104, blue light emission with a peak wavelength of 460 nm takes place. The transparent electrode 105 is formed on the organic layer 103. The refractive index of the transparent electrode 105 is about 2.0; practically, it falls within a range of from 1.95 to 2.05. Further, the first transparent resin layer 106 is disposed on the transparent electrode 105. The reflection electrode 102 functions to reflect the light emitted by the organic layer 103. In place of the reflection electrode 102, a reflector plate with optical reflectivity and the transparent electrode 105 may be used. In this case, the reflector plate is formed on the reflection-side substrate 101, with the transparent electrode 105 being formed on the reflector plate. One available example of the reflector plate is an argon (Ar) substrate.

The first transparent resin layer 106 is in contact with the transparent electrode 105 and output-side substrate 108. The first transparent resin layer 106 is made of acrylic resin, for example. By dispersing fine particles 110 of titanium oxide in the acrylic resin for use as a base material, it is possible to control the refractive index of the first transparent resin layer 106. The refractive index of first transparent resin layer 106 is settable to a given value selected from a range of from about 1.5 to 2.2. Examples of the base material of the first transparent resin layer 106 are transparent resin materials with adhesivity, including but not limited to polyethylene terephthalate (PET), silicon-based materials, acrylic materials, polyimide and epoxy. The output-side substrate 108 is situated on the first transparent resin layer 106. The refractive index of the output-side substrate 108 is about 1.5; practically, its value falls within a range of 1.50 to 1.56. In addition, the light scattering layer 109 is placed on the output-side substrate 108. The light scattering layer 109 may not be formed on an entire surface of the output-side substrate 108 as shown in Fig. 1. For example, the light scattering layer 109 is designed to be less in area than the output-side substrate 108 in an inplane direction(s) of the output-side substrate 108, thereby enabling improvement of productivity. The light scattering layer 109 is made of an acrylic resin for use as its base material, which contains fine particles 110 of zirconium oxide dispersed therein. Preferably, the base material is optically transparent and has adhesiveness. Also preferably, the refractive index of the base material of light scattering layer 109 is close in value to the refractive index of glass; more preferably, the former refractive index is the same as the latter. The recitation "the refractive index is the same" means a degree of sameness capable of attaining the intended effects of this embodiment; it does not require achievement of the exact equality in a strict sense. In practical implementation, the refractive indexes may be determined so that a difference therebetween is within a value of 0.1; more preferably, within 0.05. The base material of the light scattering layer 109 may alternatively be made of epoxy resin or PET other than the acrylic resin. Practical examples of the material of the fine particles 110 other than the zirconium oxide are barium titanate, aluminum oxide, etc. The fine particles 110 may be composed of a single kind of material selected from the above-stated examples or, alternatively, two or more kinds of materials. The refractive index of the acrylic resin is about 1.5, which is the same as the refractive index of the output-side substrate 108. It should be noted that the refractive index of each layer is measured, for example, by an optical thin-film measurement system FilmTek3000 (manufactured by YA-MAN, Ltd.) at room temperatures. The OLED shown in Fig. 1 is used to provide a light source apparatus which includes a drive device for driving the OLED.

In the device structure shown in Fig. 1, the refractive index of the transparent electrode 105 is greater than the refractive index of the first transparent resin layer 106. The refractive index of the first transparent resin layer 106 is the same as the refractive index of the output-side substrate 108. The refractive index of the output-side substrate 108 is higher than the refractive index of ambient air. The refractive index of the fine particles 110 contained in the light scattering layer 109 is higher than the refractive index of the base material of the light scattering layer and that of the output-side substrate 108.

Additionally, the refractive index of the first transparent resin layer 106 is almost equal to the refractive index of the output-side substrate 108; so, this is equivalent to the state that there is substantially no interface between the first transparent resin layer 106 and output-side substrate 108. In other words, the structure shown in Fig. 1 is deemed equivalent to a structure with lack of the first transparent resin layer 106 and also with the transparent electrode 105 and output-side substrate 108 being brought into direct contact with each other.

Although in Fig. 1 the light scattering layer 109 is situated on a side which is opposite to the existence side of the transparent electrode 105 with respect to the output-side substrate 108, the light scattering layer 109 may alternatively be placed between the output-side substrate 108 and the transparent electrode 105. By disposing the light scattering layer 109 between the output-side substrate 108 and transparent electrode 105, it is possible to protect the light scattering layer 109 by the output-side substrate 108 that is robust against deterioration.

On the other hand, in case the light scattering layer 109 is fabricated, it sometimes happens that a concavo-convex configuration is formed on the surface of the light scattering layer 109. Accordingly, by disposing the light scattering layer 109 on the opposite side to the transparent electrode 105's existence side with respect to the output-side substrate 108, the surface of the light scattering layer 109 on the concave-convex configuration-existing side is no longer contacted with the output-side substrate 108, thereby improving the productivity. In either case, the light scattering layer 109 is in contact with the output-side substrate 108.

In the case of the bottom emission type, the first transparent resin layer 106 shown in Fig. 1 is not needed, thus enabling constituent elements or members to decrease in number. On the contrary, in the case of the top emission type, the first transparent resin layer 106 is placed between the output-side substrate 108 and the transparent electrode 105; thus, it is possible to provide an ensemble of first conic solid-like transparent resin bodies 107 to be later described, thereby making it possible to reduce the thin-film waveguide mode more successfully. Note that even in the top emission type, the first transparent resin layer 106 is not needed in cases where the light scattering layer 109 is used to bond together the output-side substrate 108 and the transparent electrode 105. Additionally, even in the bottom emission type, the first transparent resin layer 106 may be provided.

As shown in Fig. 2, a distance from the interface between the reflection electrode 102 and the organic layer 103 up to the center of the luminous point 104 is represented as $a \times d$, where "a" is a value satisfying $0 < a < 1$, and d (nm) is the film thickness of the organic layer 103. In short, the value of "a" is variable in a way which follows: at the interface between reflection electrode 102 and organic layer 103, it becomes equal to zero (i.e., a=0); at the interface between organic layer 103 and transparent electrode 105, it equals one (a=1).

Here, interference conditions will be described. Fig. 3 is a diagram for explanation of the interference conditions. The center of the luminous point 104 uses any given numerical value satisfying $0 < a < 1$. Suppose that light emission takes places at the height, $a \times d$, from the interface between the reflection electrode 102 and organic layer 103. Assume that a certain point of this luminous point 104 is a point light source. An arrow in Fig. 3 indicates a propagation direction of the light emitted.

The light emitted by the light source involves a light ray traveling directly toward the transparent electrode 105 as shown by "A" in Fig. 3 and a light ray approaching the transparent electrode 105 after having once reflected at the reflection electrode 102 as shown by "B" in Fig. 3. An orientation angle $\theta$ (°) at which a phase difference between the light rays A and B is an integral multiple of $2\pi$ is the angle that exhibits the greatest enhancement of light intensity by the interference effect. Note here that the orientation angle is an angle indicative of the direction of light with the normal line direction of the interface of each layer being as an angular reference (0°).

Letting the most reinforcing orientation angle be represented by $\theta cof$ (°), it is given as:

$$\theta cof(°)=\cos^{-1}((2 \times b - \varphi m/180) \times \lambda/(4 \times n \times a \times d)) \times 180/\pi \qquad ... (Eq. 1)$$

where "b" is an integer larger than or equal to 1, $\lambda$ is the wavelength of light (nm), "n" is the refractive index of organic layer 103, d is the film thickness of organic layer 103, "a" is a value satisfying $0 < a < 1$, $\pi$ is the circle ratio, and $\varphi m$ is a phase change due to the reflection at reflection electrode 102, which varies depending on the light wavelength, angle of incidence, polarization direction, the material of reflection electrode 102 and others. In a case where the organic layer 103 is constituted from a multilayer structure including a light emission layer and hole transport layer plus electron transport layer, an average value of refractive indexes of respective layers making up the organic layer 103 is set to n. In case the reflection electrode 102 is made of aluminum, the value of $\varphi m$ is greater than or equal to 140° and less than or equal to 160° within a range of the incident angle of from 0° to 50°. In this embodiment, for brevity purposes, $\varphi m$ is set at 155° as a representative value thereof. It is apparent from Equation 1 that $\theta cof$ varies with a change in value of a. In short, $\theta cof$ is controlled by the distance from the interface between the reflection electrode 102 and organic layer 103 up to the luminous point 104.

It is noted that the luminous point 104 is a position at which electrons and holes recombine together to produce light and is settable, in a state of relatively high flexibility, by determination of the film thickness of a carrier mobility-increased organic material used for the hole transport layer or the like. Typical examples of the material of such hole transport layer are N, N'-bis (3-methylphenyl)-N, N'-diphenyl-[1,1'-biphenyl]-4, 4' diamine (TPD), 4,4'-bis[N-(1-naph-thyl)-N-phenylamino] biphenyl ($\alpha$-NPD) and other similar suitable materials. In another case where the organic layer 103 is arranged to involve a red light emission layer, green light emission layer and blue light emission layer, it is possible by letting at least one luminous point 104 satisfy Equation 1 to reduce the thin-film waveguide mode. In this regard, letting all luminous points satisfy Equation 1 makes it possible to further reduce the thin-film waveguide mode. If there is not required to satisfy Equation 1 at all luminous points 104, it becomes possible to lessen the film thickness.

The amount of light to be taken out or "extracted" into the first transparent resin layer 106 is controllable by setting θcof to an orientation angle of which one of those available directions. The setting of θcof in this way is called the interference condition setup.

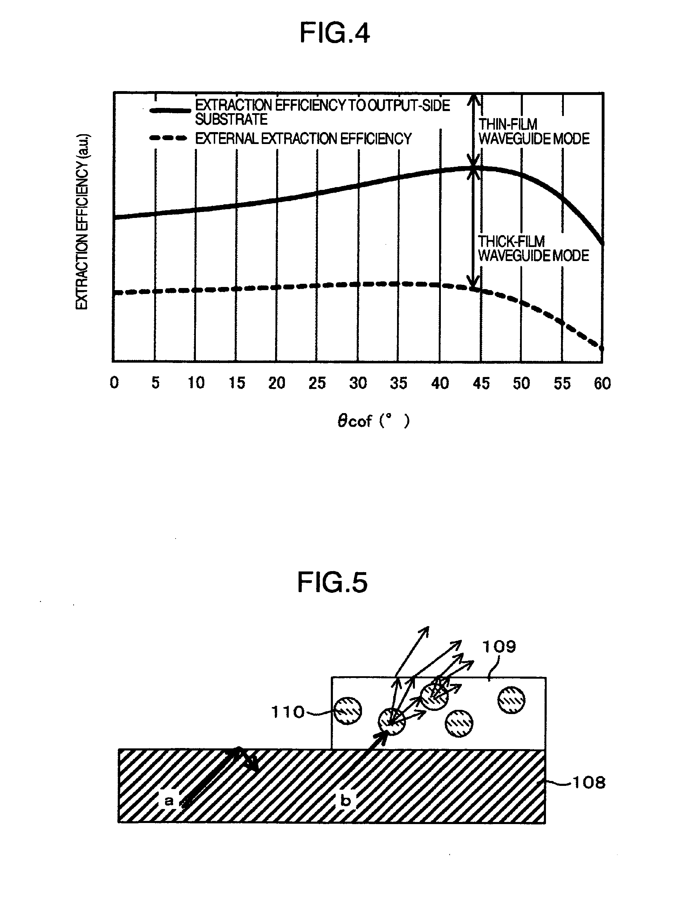

Fig. 4 is a graph showing a relationship of the efficiency of extraction of light to the output-side substrate 108 and the external extraction efficiency with respect to the angle θcof (°) in the structure of Fig. 1. By setting the θcof value so that it is greater than or equal to 35° and less than or equal to 50° (i.e., 35°≤θcof≤50°), it is possible to improve the efficiency of light extraction to the output-side substrate 108. This ensures that it is possible to reduce the thin-film waveguide mode. Preferably, setting θcof to ranging from 41° to 46° makes it possible to reduce the thin-film waveguide mode. From the foregoing, it is apparent that appropriate interference condition setup enables reduction of the thin-film waveguide mode. However, in cases where θcof is set to ranging from about 35° to 50°, the advantage of the thin-film waveguide mode reduction does not come without accompanying a penalty which follows: the thick-film waveguide mode is increased, resulting in the external extraction efficiency being unimproved. Thus, it is necessary to reduce the thick-film waveguide mode in addition to the thin-film waveguide mode reduction by the θcof setup. A thick-film waveguide mode reducing means in this embodiment will be stated below.

Fig. 5 is a diagram for explanation of the principle of the thick-film waveguide mode reduction by means of the light scattering layer 109. In a case where the light scattering layer 109 is absent, the light having its incidence angle larger than a critical angle of total reflection which is defined by the refractive index of the output-side substrate 108 and the refractive index of ambient air behaves to perform total reflection at an interface between the output-side substrate 108 and the air as indicated by a light ray path "a" in Fig. 5. This would result in an increase in thick-film waveguide mode.

To avoid this increase, fine particles 110 are dispersed in the light scattering layer 109. Upon incidence of light to such fine particles 110, the light is separated and divided by the scattering phenomena into those light rays traveling in various directions as indicated by a light path b. This results in production of light having its incidence angle smaller than the critical angle of total reflection at the interface between the output-side substrate 108 and the air, thereby making it possible to bring out the light toward the exterior, thus enabling reduction of the thick-film waveguide mode.

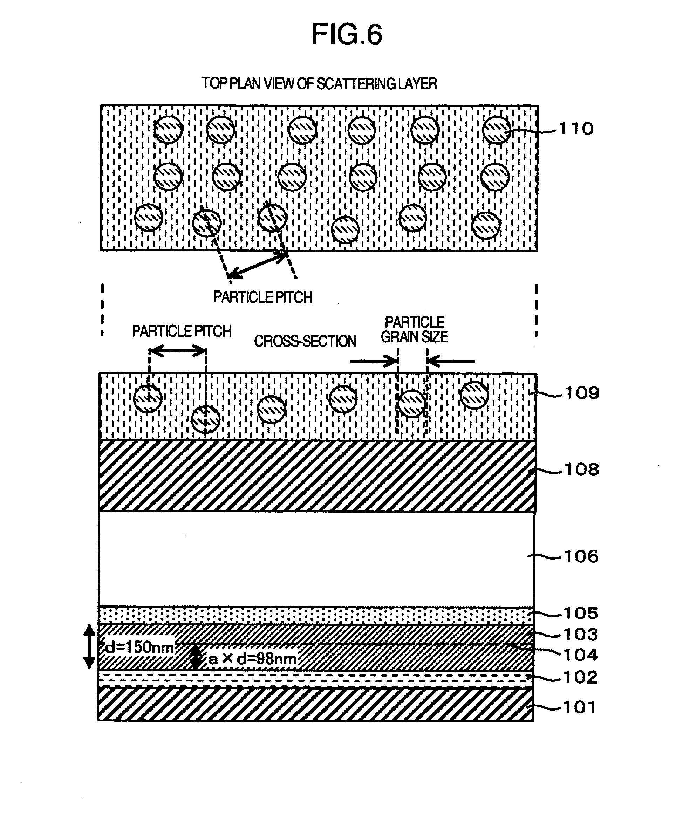

In order to efficiently extract the light to the outside by the light scattering using the light scattering layer 109, it is necessary to carefully select an appropriate grain size of the fine particles 110 (i.e., diameter of particle 110) and a suitable distribution density of fine particles 110. Consequently, as shown in Fig. 6, a relationship among the grain size of fine particles 110, the average particle pitch and the thick-film waveguide mode was simulated under the condition that the organic layer 103 was set to 150 nm in thickness, the height of the luminous point 104 from the reflection electrode 102 was set at 98 nm, and the refractive index of the first transparent resin layer 106 was set to 1.5. Note here that the particle pitch is a distance between neighboring ones of the fine particles 110 in a direction along the layer plane as shown in Fig. 6. The average particle pitch is an average value of pitch values of those of all the fine particles 110 within a square surface region of the light scattering layer 109 with an area of 20μm by 20μm. The height, 98 nm, of the luminous point 104 from the reflection electrode 102 is the value in the case of θcof being set to 42°. Additionally, in case the light scattering layer 109 contains particles of different grain sizes, the grain size of a particle 110 may be thought as the average grain size.

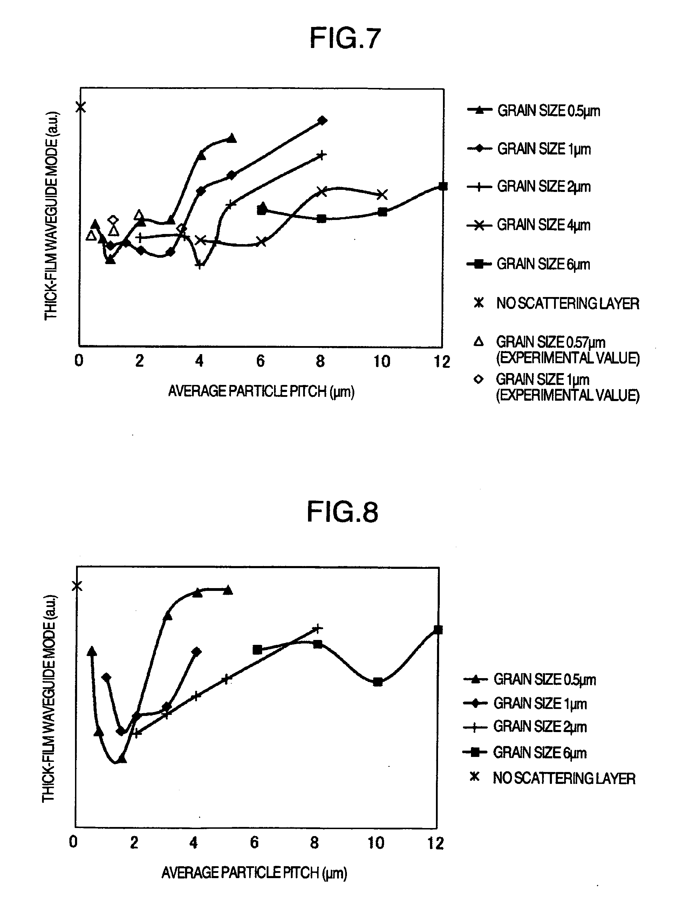

Figs. 7 and 8 show simulation results in the case of the refractive index of fine particles 110 being set at 2.4 and 1.8, respectively. It is noted that a thick-film waveguide mode in the case of the light scattering layer 109 being absent is indicated so that the average particle pitch is 0μm for purposes of convenience in discussion herein. Also indicated in the graphs are thick-film waveguide modes which are estimated from light amount measurement results of OLEDs that were fabricated by using as the fine particles 110 of light scattering layer 109 those fine particles 110 of zirconium oxide having a refractive index 2.4 at a refractive index 2.4, a grain size of 0.57μm and grain size of 1.0μm, respectively.

As shown in Fig. 7, in the case of the refractive index of fine particles being set to 2.4, the thick-film waveguide mode was reduced within a particle grain size range of from 0.5μm to 6.0μm and within an average particle pitch range of 0.5μm to 12μm. More preferably, the thick-film waveguide mode was reduced more successfully within a particle grain size range of 0.5μm to 4.0μm and within an average particle pitch range of 0.5μm to 7.0μm.

Seeing in greater detail, a preferable average particle pitch exists for each grain size.

In the case of the grain size of fine particles 110 being set to 0.5μm, the average particle pitch is preferably set so that it ranges from 0.5μm to 3.0μm whereas an optimal value of the average particle pitch is 1.0μm. Regarding the relationship of the grain size of particles 110 versus the average particle pitch, the average particle pitch is preferably set at 1.0 time to 6.0 times the grain size of particles 110; in particular, the best possible value of it is 2.0 times.

In the case of the grain size of fine particles 110 being set to 1μm, the average particle pitch is preferably set to ranging from 1.0μm to 3.5μm; an optimum value of the average particle pitch is 3.0μm. Regarding the relationship of the grain size of particles 110 and the average particle pitch, the average particle pitch is preferably set at 1.0 to 3.5 times the grain size of particles 110; in particular, the best value of it is 3.0 times.

In case the grain size of fine particles 110 is 2μm, the average particle pitch is preferably set to ranging from 2.0μm to 4.75μm; an optimum value of the average particle pitch is 4.0μm. Regarding the relation of the grain size of particles 110 and the average particle pitch, the average particle pitch is preferably set at 1.0 to 2.4 times the grain size of particles 110; in particular, the best value is 2.0 times.

In case the grain size of fine particles 110 is 4μm, the average particle pitch is preferably set to ranging from 4.0μm to 7.0μm; an optimum value of the average particle pitch is 6μm. Concerning the relation of the grain size of particles 110 and the average particle pitch, the average particle pitch is preferably set at 1.0 to 1.8 times the grain size of particles 110; in particular, the best value is 1.50 times.

As shown in Fig. 8, in case the refractive index of fine particles 110 is 1.8, the thick-film waveguide mode is reduced within a particle grain size range of from 0.5μm to *6.0μm* and within an average particle pitch range of 0. 5μm to 12μm. More preferably, the thick-film waveguide mode is reduced more successfully within a particle grain size range of 0.5μm to 2.0μm and within an average particle pitch range of 0.5μm to 4.0μm.

Seeing in greater detail, a preferable average particle pitch exists for each grain size.

In the case of the grain size of fine particles 110 being set to 0.5μm, preferable results are obtained when the average particle pitch falls within a range of from 0.5μm to 2.75μm. An optimal value of the average particle pitch is 1.50μm. Regarding the relationship of the grain size of particles 110 versus the average particle pitch, the average particle pitch is preferably set at 1.0 time to 5.5 times the grain size of particles 110; in particular, the best possible value thereof is 3.0 times.

In case the grain size of fine particles 110 is 1μm, preferable results are obtained when the average particle pitch ranges from 1.0μm to 3.25μm; an optimum value of the average particle pitch is 1.5μm. Regarding the relationship of the grain size of particles 110 and the average particle pitch, the average particle pitch is preferably set at 1.0 to 3.3 times the grain size of particles 110; in particular, the best value is 1.5 times.

In case the grain size of fine particles 110 is 2μm, preferable results are obtained when the average particle pitch ranges from 2.0μm to 4.0μm; an optimum value of the average particle pitch is 2.0μm. As for the relationship of the grain size of particles 110 and the average particle pitch, the average particle pitch is preferably set at 1.0 to 2.0 times the grain size of particles 110; in particular, the best value is 1.0 time.

From the above results, in the case of fine particles 110 with grain sizes of 0.5μm to 6.0μm being used as specific fine particles, when the average particle pitch of such specific particles is set to ranging from 1.0 to 6.0 times the grain size of specific particles, it is possible to reduce the thick-film waveguide mode. In addition, when the average particle pitch of specific particles is greater than or equal to the grain size of specific particles and less than or equal to 12μm, it is possible to reduce the thick-film waveguide mode.

More preferably, in case fine particles 110 with grain sizes of 0.5μm to 2.0μm are used as special fine particles, when the average particle pitch of such special particles is 1.0 to 3.0 times the grain size of special particles, it is possible to further reduce the thick-film waveguide mode. In addition, when the average particle pitch of special particles is greater than or equal to the grain size of special particles and less than or equal to 4.0μm, it is possible to further reduce the thick-film waveguide mode.

It is noted that insofar as advantageous effects of this embodiment are attainable, the fine particles 110 may contain therein those particles 110 with grain sizes smaller than 0.5μm or other particles 110 with grain sizes larger than 6.0μm.

As has been described above, it is possible by appropriate setup of the luminous point 104 to reduce the thin-film waveguide mode. In addition, by appropriately setting the grain size and distribution density of the fine particles 110 in the light scattering layer 109, it is possible to reduce the thick-film waveguide mode. With these schemes, it becomes possible to obtain highly increased light extraction efficiency.

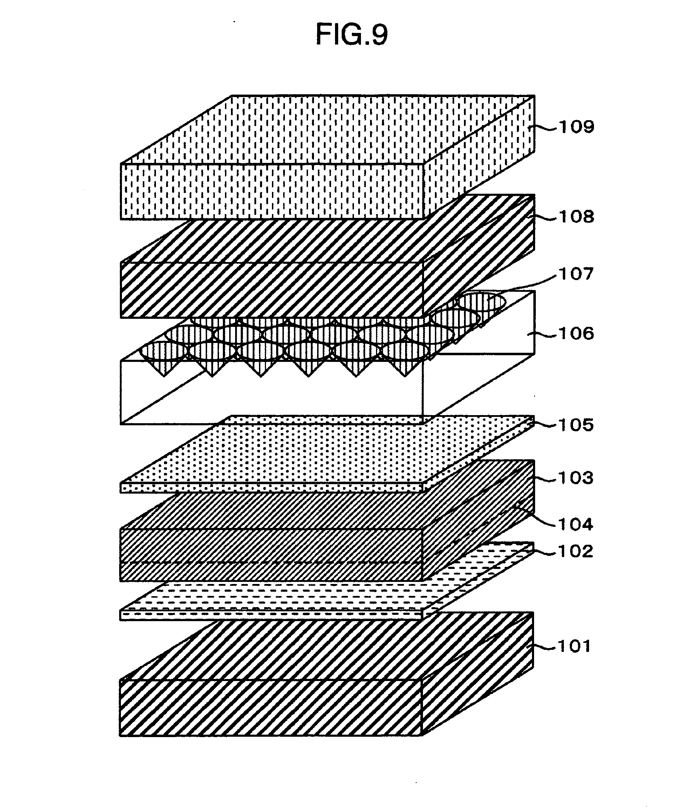

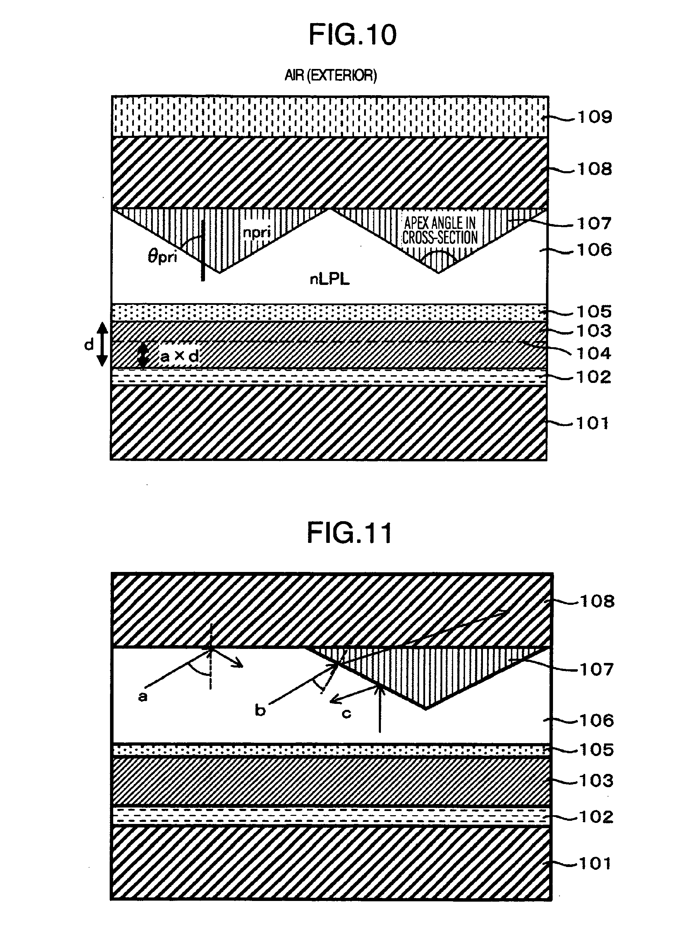

Also importantly, it is possible to further reduce the thin-film waveguide mode by employing a device structure which will be described below. An exploded perspective view of such structure capable of reducing the thin-film waveguide mode is shown in Fig. 9; a cross-sectional view thereof is shown in Fig. 10. An ensemble of first conic solid-like transparent resin bodies 107 is buried or embedded in a first transparent resin layer 106 in such a manner that each conic resin has its bottom face adhered to a surface of an output-side substrate 108. The first conic solid-like transparent resin 107 has its refractive index which is settable to any value falling within a range of from 1.4 to 1.8. In a normal line direction of the output-side substrate 108, the first conic solid-like transparent resin 107 has an increasing expanse from the first transparent resin layer 106 toward the output-side substrate 108. Note that in this embodiment, a spread angle of the first conic solid-like transparent resin 107 in the direction toward the output-side substrate 108 is represented by θpri as shown in Fig. 10. The refractive index of the first conic solid-like transparent resin 107 is denoted by npri; the refractive index of transparent resin is given as nLPL.

Fig. 11 is a principle diagram of thin-film waveguide mode reduction in this embodiment. By disposing the first conic solid-like transparent resin bodies 107 in the top surface of the first transparent resin layer 106, it is possible to reduce the thin-film waveguide mode. The refractive index of first conic solid-like transparent resin 107 is smaller than the refractive index of first transparent resin layer 106 and, simultaneously, greater than or equal to the refractive index of output-side substrate 108. In cases where the first conic solid-like transparent resin 107 having a circular cone shape is not provided, light had experienced total reflection at an interface between the first transparent resin layer 106 and the output-side substrate 108 along a light path shown by "a" in Fig. 11. Consequently, by inserting the first conic solid-like transparent resin 107, a light path is formed as shown by "b" in Fig. 11. More specifically, the angle of incidence of light from the first transparent resin layer 106 into the first conic solid-like transparent resin 107 becomes less than the incidence angle of light from the first transparent resin layer 106 to the output-side substrate 108 as shown by "a" in Fig. 11 whereby total reflection does not take place so that the light goes out into the output-side substrate 108. This makes it possible to reduce the thin-film waveguide mode. Note here that the light path b in Fig. 11 is indicated in an exemplary case where the first conic solid-like transparent resin 107 is the same in refractive index as the output-side substrate 108. Note however that there is a case where the light traveling in the normal line direction performs total reflection undesirably at an interface between the first conic solid-like transparent resin 107 having the circular cone shape and the first transparent resin layer 106, such as a light ray shown by "c" in Fig. 11. Also note that in case the first conic solid-like transparent resin 107 is higher in refractive index than the output-side substrate 108, the light experiences unwanted total reflection at the interface between the first conic solid-like transparent resin 107 of the circular cone shape and the output-side substrate 108. Thus, for minimization of the thin-film waveguide mode, there is a need to optimize several parameters to be indicated follow.

Optimization-required parameters are as follows:

· nLPL
· npri
· θpri
. θcof

The optimization of these parameters will be described below.

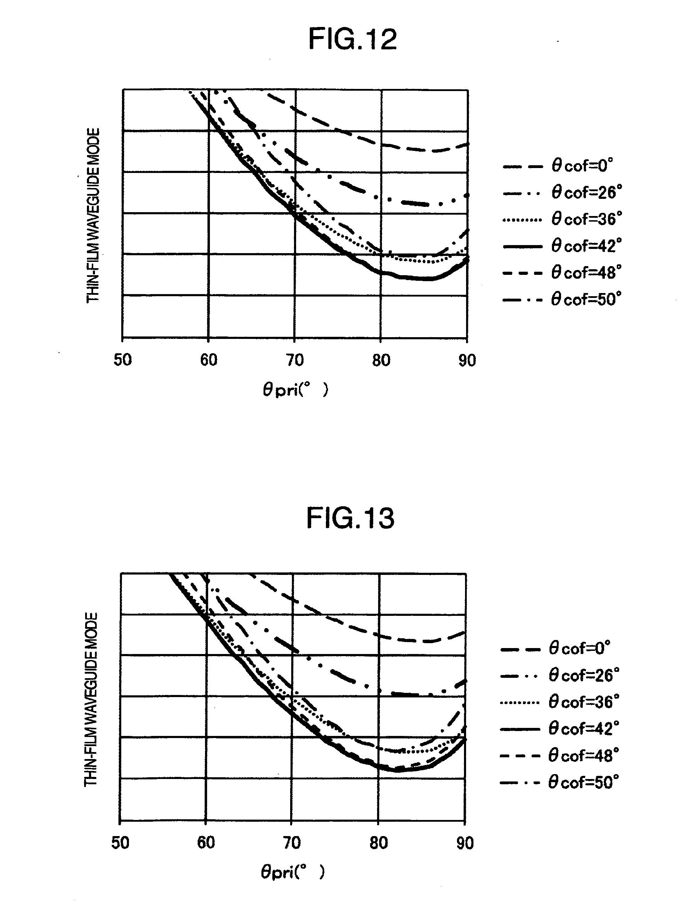

Fig. 12 shows simulation results of a relationship of θpri and relative value of thin-film waveguide mode under various interference conditions while using the following setup values: 460 nm for the light wavelength, 150 nm for the film thickness of organic layer 103, 1.6 for the refractive index of first transparent resin layer 106, and 1.5 for the refractive index of first conic solid-like transparent resin 107 of the circular cone shape type. A thin-film waveguide mode in the case of θpri=90° is equivalent to the value of a case where the first conic solid-like transparent resin 107 is not used; a region having its value lower than this value makes an effect on reduction of the thin-film waveguide mode by the first conic solid-like transparent resin 107.

The relative value of the thin-film waveguide mode exhibits strong dependency upon θcof and θpri. The value remains low when θcof ranges from 36° to 48° and θpri ranges from about 80° to 87° (i.e., 36°≤ θcof≤48° and 80°≤ θpri≤87°); preferably, it becomes the lowest value when θcof=42° and θpri=85°.

Additionally, from Equation 1, the distance a×d up to the center of luminous point 104 corresponding to the θcof range of from 36° to 48° is given as: (2-155/180)λ/4/n/cos36°≤ a×d ≤(2-155/180)λ/4/n/cos48°. That is, the distance is more than or equal to 90 nm and less than or equal to 109 nm.

Fig. 13 shows simulation results of the relationship of θpri and relative value of thin-film waveguide mode under various interference conditions while setting the light's wavelength to 460 nm, the film thickness of organic layer 103 to 150 nm, the refractive index of first transparent resin layer 106 at 1.7, and the refractive index of first conic solid-like transparent resin 107 at 1.5.

The thin-film waveguide mode is kept low in value when 36°≤ θ6cof≤48° and 75°≤ θpri≤85°; preferably, it becomes the lowest value when θcof=42° and θpri=82°.

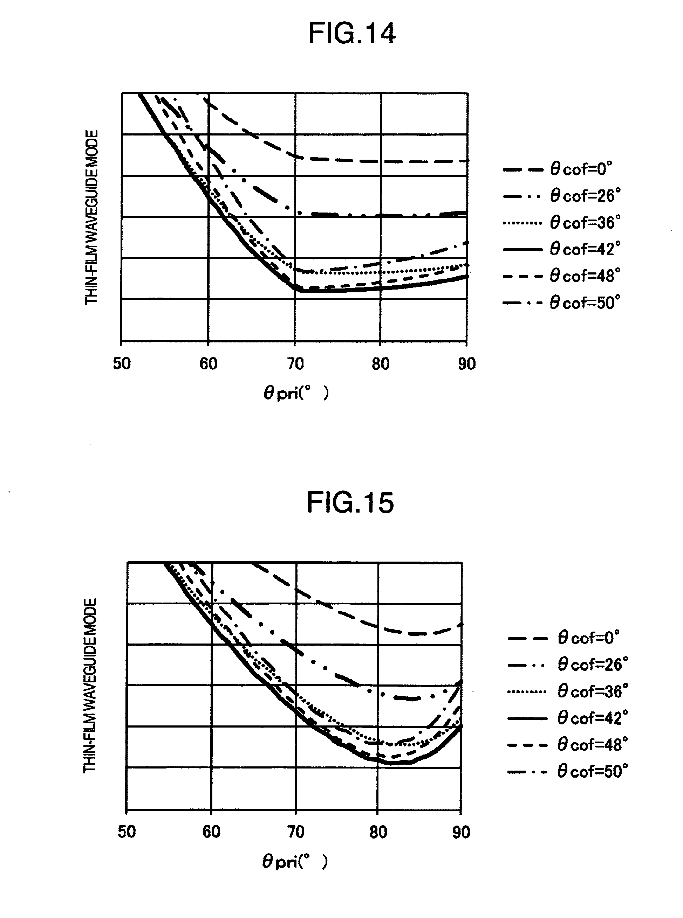

Fig. 14 shows simulation results of the relationship of θpri and relative value of thin-film waveguide mode under various interference conditions while setting the light's wavelength to 460 nm, the film thickness of organic layer 103 to 150 nm, the refractive index of first transparent resin layer 106 at 1.7, and the refractive index of first conic solid-like transparent resin 107 at 1.6.

The thin-film waveguide mode is low in value when 36°≤ θcof≤48° and 70°≤ θpri≤80°; preferably, it becomes the lowest value when θcof=42° and θpri=71°.

Fig. 15 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 1.8, and the refractive index of first conic solid-like transparent resin 107 at 1.5.

The thin-film waveguide mode is low in value when 36°≤ θcof≤48° and 75°≤ θpri≤85°; preferably, it becomes the lowest value when θcof=42° and θpri=82°.

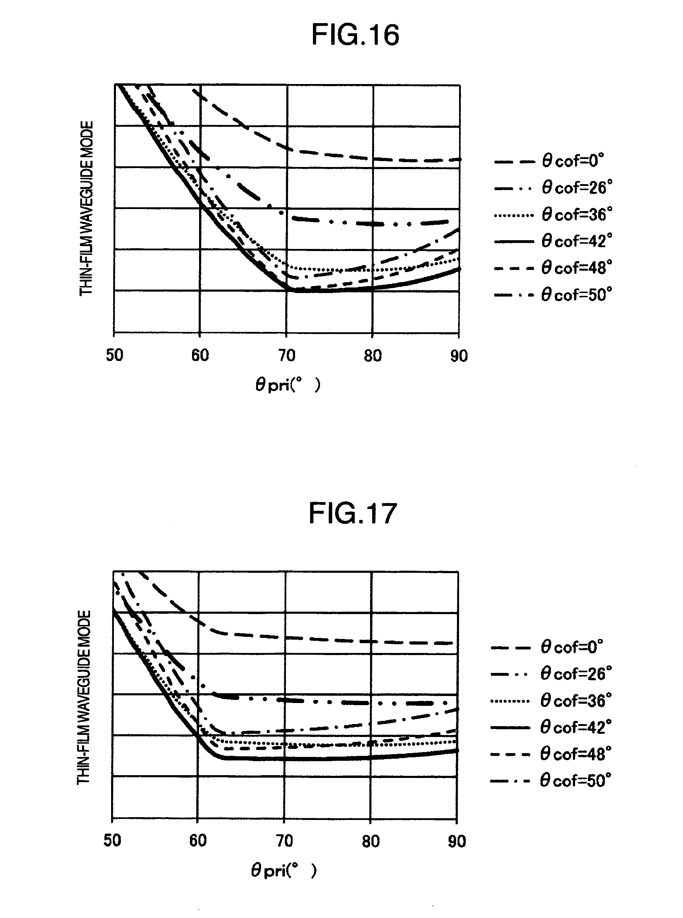

Fig. 16 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 1.8, and the refractive index of first conic solid-like transparent resin 107 at 1.6.

The thin-film waveguide mode is low in value when 36°≤ θcof≤48° and 70°≤ θpri≤80°; preferably, it becomes the lowest value when θcof=42° and θpri=74°.

Fig. 17 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 1.8, and the refractive index of first conic solid-like transparent resin 107 at 1.7.

The thin-film waveguide mode is low in value when 36°≤ θcof≤48° and 62°≤ θpri≤80°; preferably, it becomes the lowest value when θcof=42° and θpri=71°.

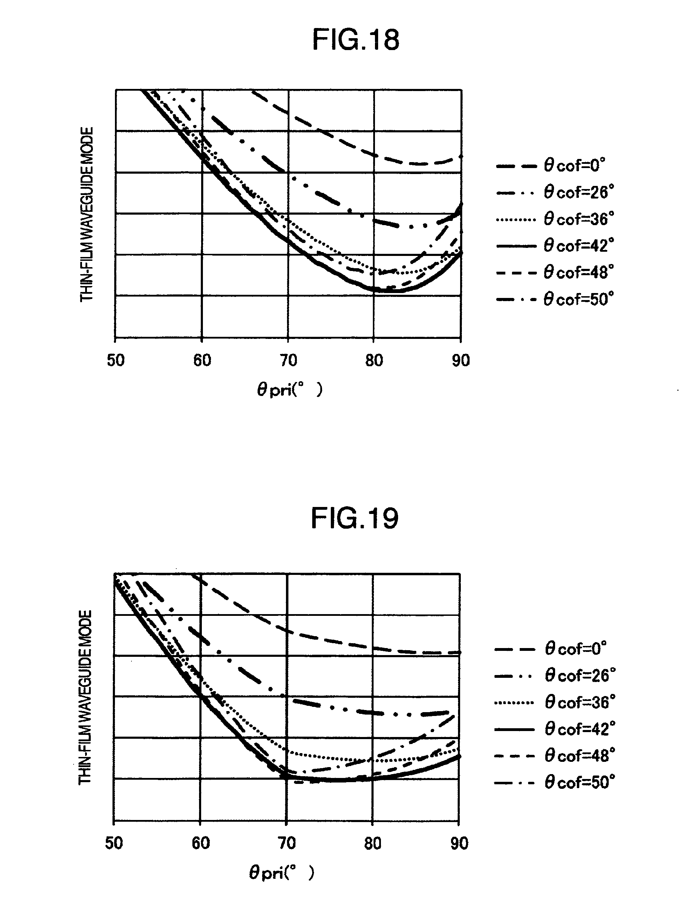

Fig. 18 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 1.9, and the refractive index of first conic solid-like transparent resin 107 at 1.5.

The thin-film waveguide mode is low in value when 36°≤ θcof≤48° and 75°≤ θpri≤85°; preferably, it becomes the lowest value when θcof=42° and θpri=83°.

Fig. 19 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 1.9, and the refractive index of first conic solid-like transparent resin 107 at 1.6.

The thin-film waveguide mode is low in value when 36°≤ θcof≤48° and 70°≤ θpri≤80°; preferably, it becomes the lowest value when θcof=42° and θpri=76°.

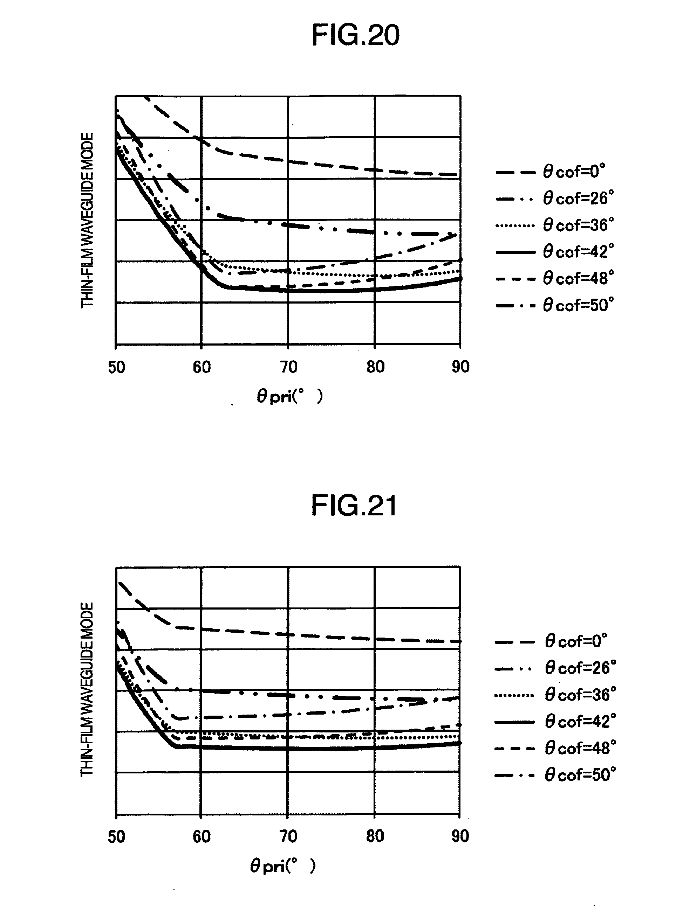

Fig. 20 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 1.9, and the refractive index of first conic solid-like transparent resin 107 at 1.7.

The thin-film waveguide mode is low in value when 36°≤θcof≤48° and 63°≤ θpri≤80°; preferably, it becomes the lowest value when θcof=42° and θpri=74°.

Fig. 21 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 1.9, and the refractive index of first conic solid-like transparent resin 107 at 1.8.

The thin-film waveguide mode is low in value when 36°≤ θcof≤48° and 57°≤ θpri≤80°; preferably, it becomes the lowest value when θcof=42° and θpri=74°.

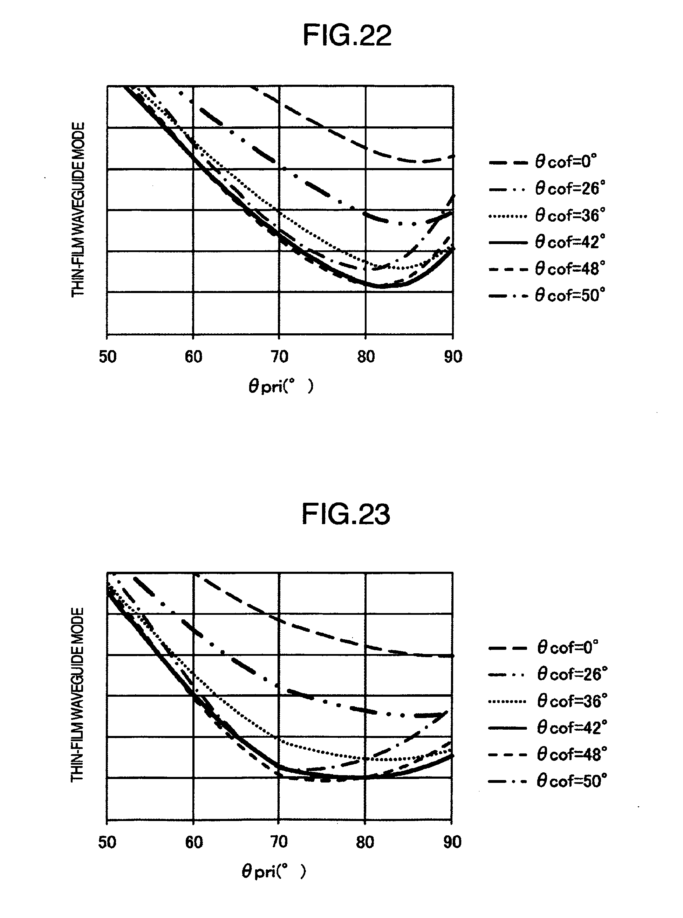

Fig. 22 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 2.0, and the refractive index of first conic solid-like transparent resin 107 at 1.5.

The thin-film waveguide mode is low in value when 36°≤ θcof≤48° and 75°≤ θpri≤85°; preferably, it becomes the lowest value when θcof=42° and θpri=82°.

Fig. 23 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 2.0, and the refractive index of first conic solid-like transparent resin 107 at 1.6.

The thin-film waveguide mode is low in value when 36°≤ θcof≤48° and 70°≤ θpri≤80°; preferably, it becomes the lowest value when θco=48° and θpri=75°.

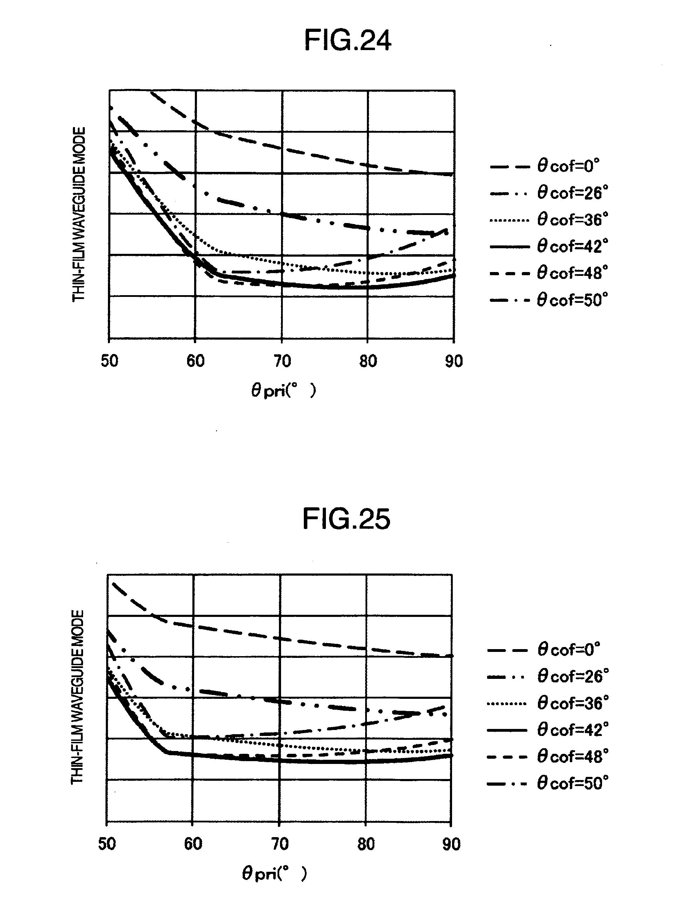

Fig. 24 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 2.0, and the refractive index of first conic solid-like transparent resin 107 at 1.7.

The thin-film waveguide mode is low in value when 36°≤ θcof≤48° and 70°≤ θpri≤85°; preferably, it becomes the lowest value when θcof=42° and θpri=78°.

Fig. 25 shows simulation results of the relationship of θpri and relative value of thin-film waveguide mode under various interference conditions while setting the light wavelength to 460 nm, the film thickness of organic layer 103 to 150 nm, the refractive index of first transparent resin layer 106 at 2.0, and the refractive index of first conic solid-like transparent resin 107 at 1.8.

The thin-film waveguide mode is low in value when 36°≤ θcof≤48° and 70°≤ θpri≤85°; preferably, it becomes the lowest value when θcof=42° and θpri=78°.

Vertical axes of the graphs of Figs. 12 to 25 are all within the same range.

Next, a relationship of the refractive index for minimization of the thin-film waveguide mode will be described below.

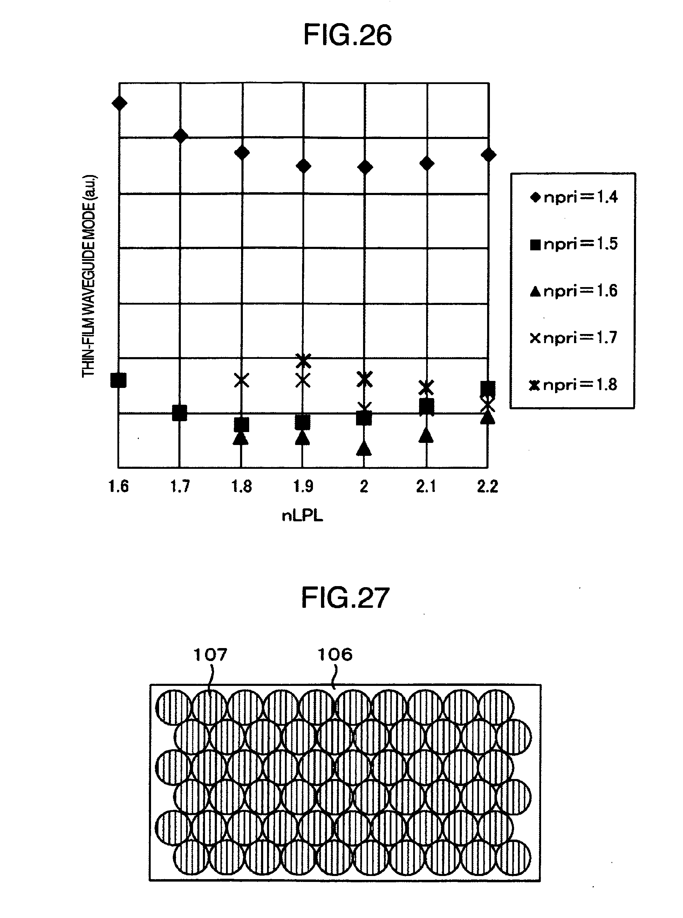

Fig. 26 is a graph showing a relation of thin-film waveguide mode plotted in vertical axis versus refractive index nLPL of first transparent resin layer 106 plotted in transverse axis while letting respective values of the refractive index npri (1.4, 1.5, 1.6, 1.7 and 1.8) of first conic solid-like transparent resin 107 in case θcof and θpri are optimized (i.e., these are set in the condition that the thin-film waveguide mode becomes the lowest value).

In order to reduce the thin-film waveguide mode more successfully, it is recommended that the refractive index nLPL of first transparent resin layer 106 is set to ranging from 1.7 to 2.0 (i.e., 1.7≤nLPL≤2.0). Preferably, the refractive index of first conic solid-like transparent resin 107 is set to larger than or equal to 1.5 and less than 1.7 (1.5≤ nLPL<1.7).

The relationship of these refractive indexes and thin-film waveguide mode is closely related to respective refractive index ratios of the first transparent resin layer 106, first conic solid-like transparent resin 107 and output-side substrate 108. For example, it becomes easier for light to enter the first conic solid-like transparent resin bodies 107 from first transparent resin layer 106 when the refractive index of first conic solid-like transparent resin 107 becomes higher in value; adversely, it becomes difficult for the light to enter the output-side substrate 108 from first conic solid-like transparent resin 107. In view of this, it is recommended that the ratio, nLPL/nglass, of the refractive index of first transparent resin layer 106 to the refractive index of output-side substrate 108 is set to ranging from 1.13 to 1.33, where nLPL is the refractive index of first transparent resin layer 106, and nglass is the refractive index of output-side substrate 108. It is also recommended that the ratio, npri/nglass, of the refractive index of first conic solid-like transparent resin 107 to the refractive index of output-side substrate 108 is set to ranging from 1 to 1.13.

Note here that although the refractive indexes have been stated using discrete values with a resolution of 0.1, refractive indexes of actual members are continuous values; so, the above-stated refractive index values are expressed by approximate values, each of which is obtained by rounding the refractive index of an actual member at the second decimal place. Rounding refractive indexes results in no appreciable variation in the above-stated preferable essential factors for reducing the thin-film waveguide mode, such as the angle range of θpri, etc.

As has been stated above, reduction of the thin-film waveguide mode is achievable by inserting the first conic solid-like transparent resin 107 and appropriately controlling the relationship of the refractive indexes of the first transparent resin layer 106 and first conic solid-like transparent resin 107. In addition, by adequately controlling an apex angle of the first conic solid-like transparent resin 107 and the location of the luminous point 104 in the organic layer 103, it is possible to reduce the thin-film waveguide mode.

Fig. 27 is a plan view of a surface of the first transparent resin layer 106 on the output-side substrate 108 side. The circular cone-shaped bodies of the first conic solid-like transparent resin 107 are disposed in a densely filling layout as shown in Fig. 27. With this dense fill layout, gaps among neighboring cones of the first conic solid-like transparent resin 107 become smaller in size, thus enabling achievement of further reduction of the thin-film waveguide mode.

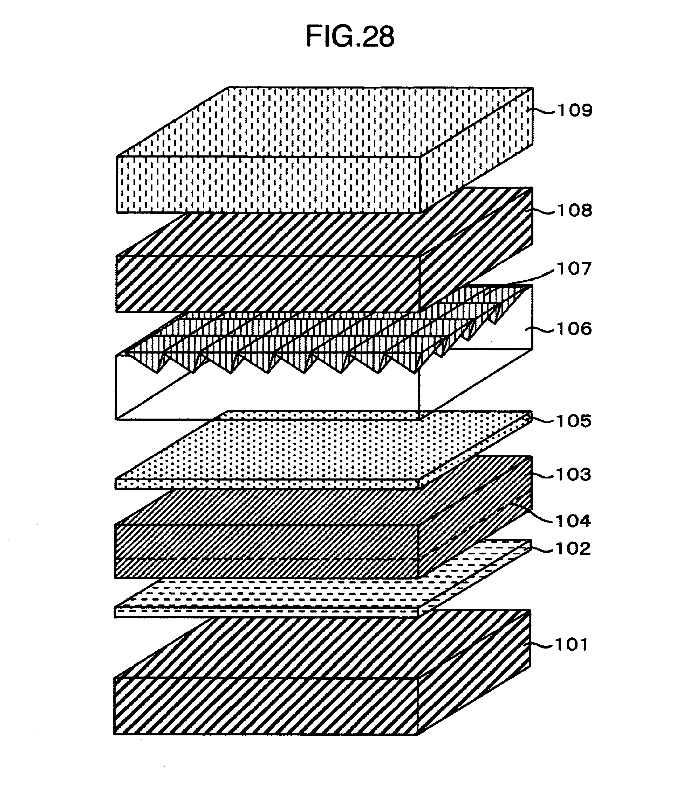

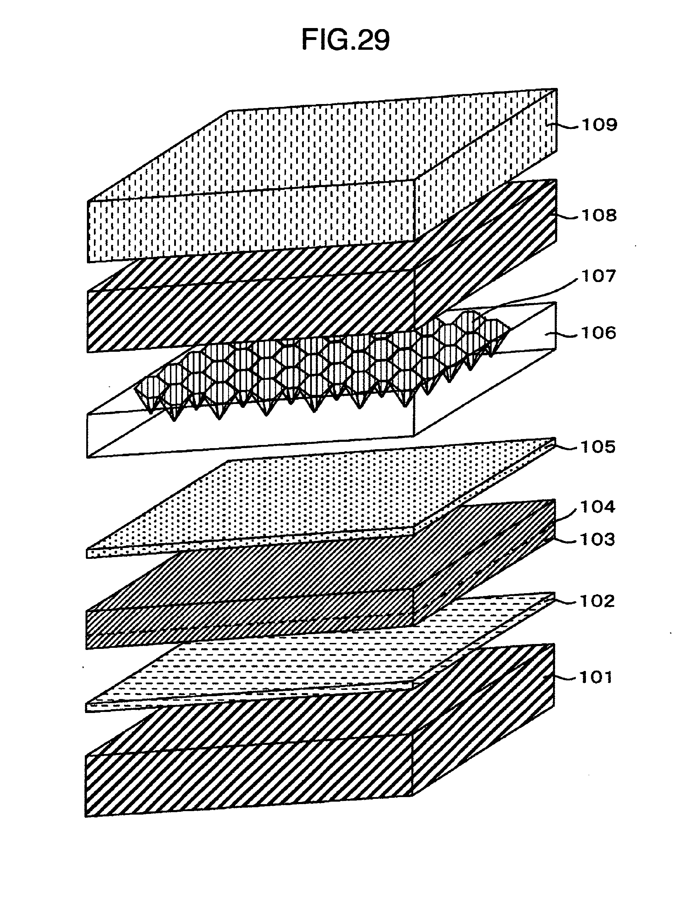

The first conic solid-like transparent resin 107 is not limited to the one of the circular cone type shown in Fig. 9, and may be arranged to have either a quadrangular pyramid-like shape shown in Fig. 28 or a six-sided pyramid shape shown in Fig. 29. Note however that it is desirable to arrange the shape of first conic solid-like transparent resin 107 to have the circular conic shape. This can be said because the thin-film waveguide mode is reducible in all inplane directions of the OLED device.

As has been indicated in this embodiment, it is possible to reduce the thick-film waveguide mode by appropriate setup of the grain size and the layout density of the fine particles 110 of the light scattering layer 109. It is also possible to reduce the thin-film waveguide mode by appropriately performing setup of the luminous point 104 or, alternatively, setup of both the refraction index of first transparent resin layer 106 and the refractive index and spreading angle of first conic solid-like transparent resin 107 in addition to the setup of the luminous point 104. With the schemes stated above, highly enhanced light extraction efficiency is obtainable in the OLED of this embodiment. Additionally, with the above-noted arrangement, color mixture is accelerated in cases where two or more luminous layers having different colors are multilayered.

(Embodiment 2)

Another embodiment of this invention will be set forth in detail.

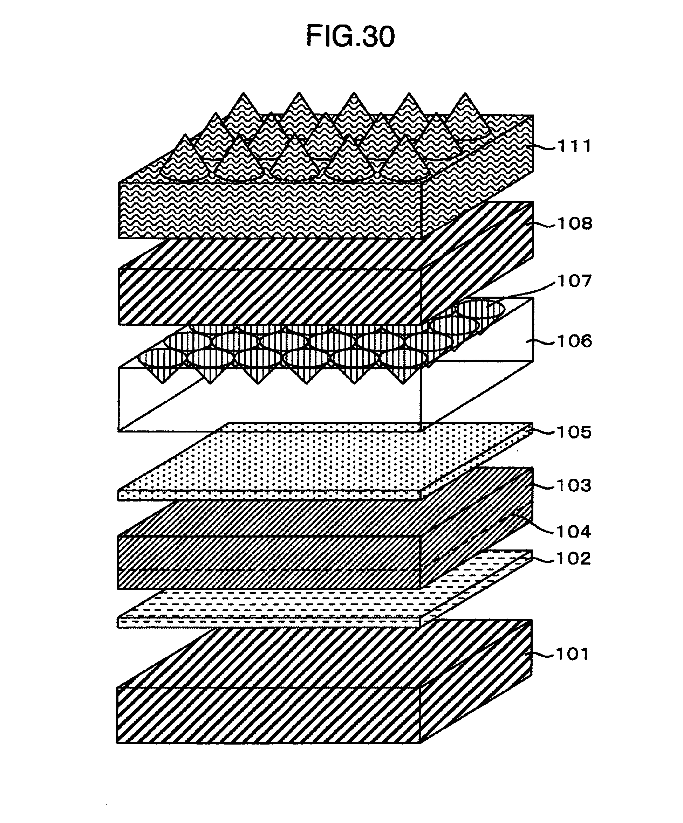

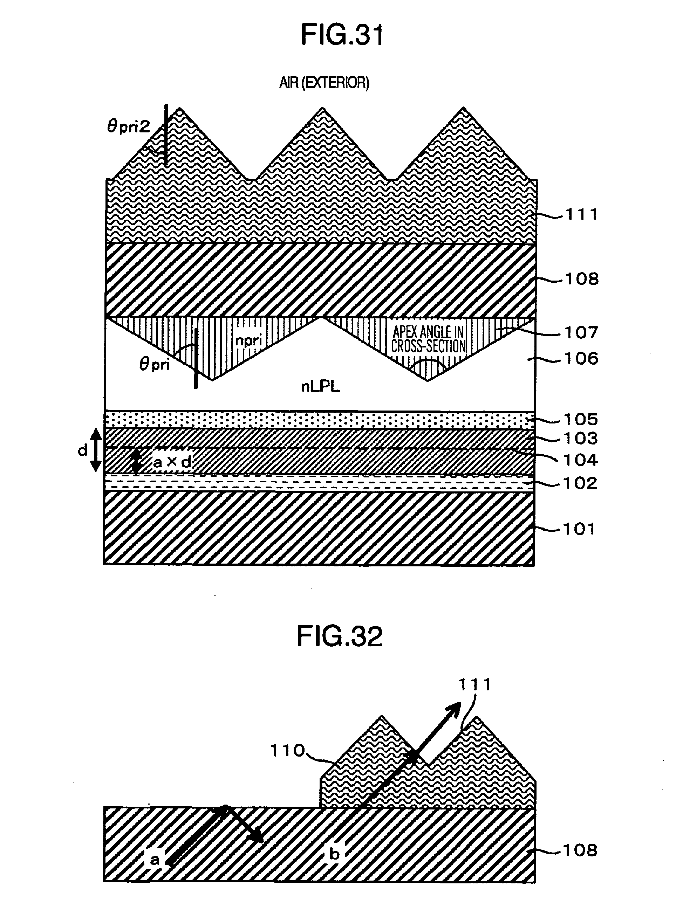

Fig. 30 is an exploded perspective view of an organic light emitting diode (OLED) in accordance with this embodiment. Fig. 31 is a cross-sectional view of the OLED of this embodiment. The OLED of this embodiment has a reflection-side substrate 101, aluminum reflection electrode 102, organic layer 103, transparent electrode 105, first transparent resin layer 106, first conic solid-like transparent resin bodies 107, output-side substrate 108 and second conic solid-like transparent resin 111. Although Figs. 30-31 are for explanation of the top-emission type, the bottom-emission type may alternatively be employable. On the aluminum reflection electrode 102 which is formed on the reflection-side substrate 101, the organic layer 103 composed of organic molecules is formed. The organic layer 103 includes a luminous point 104. From this luminous point 104, blue light emission with a peak wavelength of 460 nm takes place. On the organic layer 103, the transparent electrode 105 is formed. On this transparent electrode 105, the first transparent resin layer 106 is disposed. The first transparent resin layer 106 has its top surface in which are embedded the first conic solid-like transparent resin bodies 107 each having a bottom face adhered to a surface of the output-side substrate 108.

The first conic solid-like transparent resin 107 of the circular cone shape has a refractive index of about 1.5. The output-side substrate 108 is situated on the first transparent resin layer 106. The first conic solid-like transparent resin 107 has expanse toward the output-side substrate 108 from the first transparent resin layer 106 in a normal line direction of the output-side substrate 108. The OLED also has the second conic solid-like transparent resin 111 on the output-side substrate 108. Although in Fig. 30 the second conic solid-like transparent resin 111 is constituted from a resin layer of rectangular parallelepiped and a plurality of circular cone-shaped resin bodies disposed thereon, the rectangular resin layer is not always required. Note however that it is possible by fabricating a planar resin layer such as the rectangular resin to mold the second conic solid-like transparent resin 111 in the process of pressing a metal mold of circular cone-shaped resin against the planar resin. The second conic solid-like transparent resin 111 has its bottom face which is adhered to an air-side surface of the output-side substrate 108. The second conic solid-like transparent resin 111 is fabricated by molding an acrylate resin. The refractive index of such acrylate resin is about 1.5, which is the same as the refractive index of the output-side substrate 108. In the normal line direction of the output-side substrate 108, the second conic solid-like transparent resin 111 has expanse from ambient air toward the output-side substrate 108 (in the opposite direction to the direction of light extraction from the organic layer 103). Note here that in this description, the expansion angle of the second conic solid-like transparent resin 111 in the direction toward the output-side substrate 108 is represented by $\theta$pri2 as shown in Fig. 31.

A thin-film waveguide reduction technique mode of this embodiment is similar to the scheme that has been indicated in the embodiment 1 stated supra.

Fig. 32 is a diagram for explanation of the principle of the thick-film waveguide mode reduction in this embodiment. In a case where the second conic solid-like transparent resin 111 is not provided, light having its incident angle larger than the total reflection critical angle at an interface between the output-side substrate 108 and the air behaves to perform total reflection at the interface between output-side substrate 108 and air as indicated by a light path "a" in Fig. 32. This results in an increase in thick-film waveguide mode. Upon incidence of light into the second conic solid-like transparent resin 111, the incident angle becomes smaller due to the inclination of the second conic solid-like transparent resin 111 as indicated by a light path "b" in Fig. 32, resulting in extraction of the light to the exterior, thereby enabling reduction of the thick-film waveguide mode.

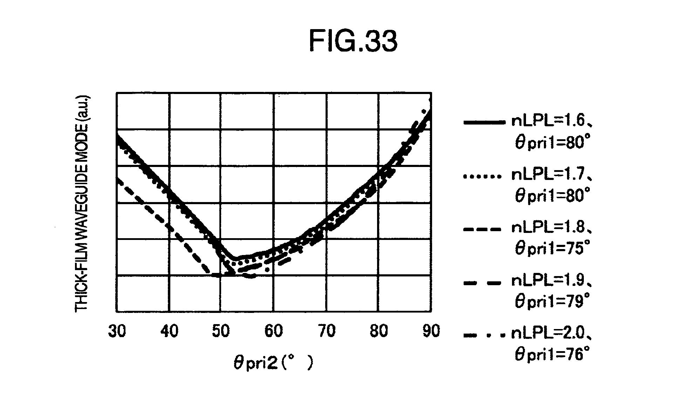

Fig. 33 is a graph showing the effect of thick-film waveguide mode reduction achieved by this embodiment. Under preconditions of $\theta$cof=42° and the first conic solid-like transparent resin 107's refractive index being set at 1.5, a relationship of the thick-film waveguide mode plotted in the vertical axis versus $\theta$pri2 (°) plotted in lateral axis is shown in Fig. 33 with the refractive index nLPL of first transparent resin layer 106 and $\theta$pri1 of first conic solid-like transparent resin 107 being used as parameters. The refractive index nLPL of first transparent resin layer 106 was set to several values, such as 1.6, 1.7, 1.8, 1.9 and 2.0, whereas $\theta$pri1 of first conic solid-like transparent resin 107 was at 80°, 80°, 75°, 79° and 76°, respectively.

A thin-film waveguide mode in the case of $\theta$pri2=90° is equivalent to the value in the case of the second conic solid-like transparent resin 111 being unused; a region having its value lower than this value makes an effect on reduction of the thin-film waveguide mode owing to the second conic solid-like transparent resin 111. It can be seen that it is more preferable to set $\theta$pri2 to ranging from 45° to 60°.

The second conic solid-like transparent resin 111 may be designed to have any one of the circular conic shape, the pyramid-like shape and the six-sided pyramid shape. By employing a dense fill layout, it is possible to enhance the efficiency more significantly for the same reason as that described concerning the layout of the first transparent resin layer 106 in the embodiment 1.

(Embodiment 3)

Another embodiment of this invention will be explained in detail.

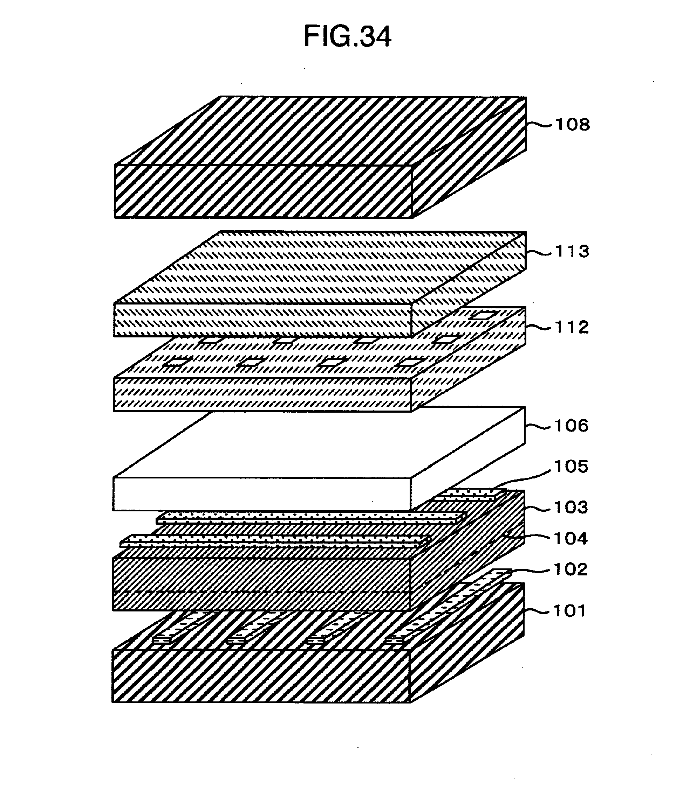

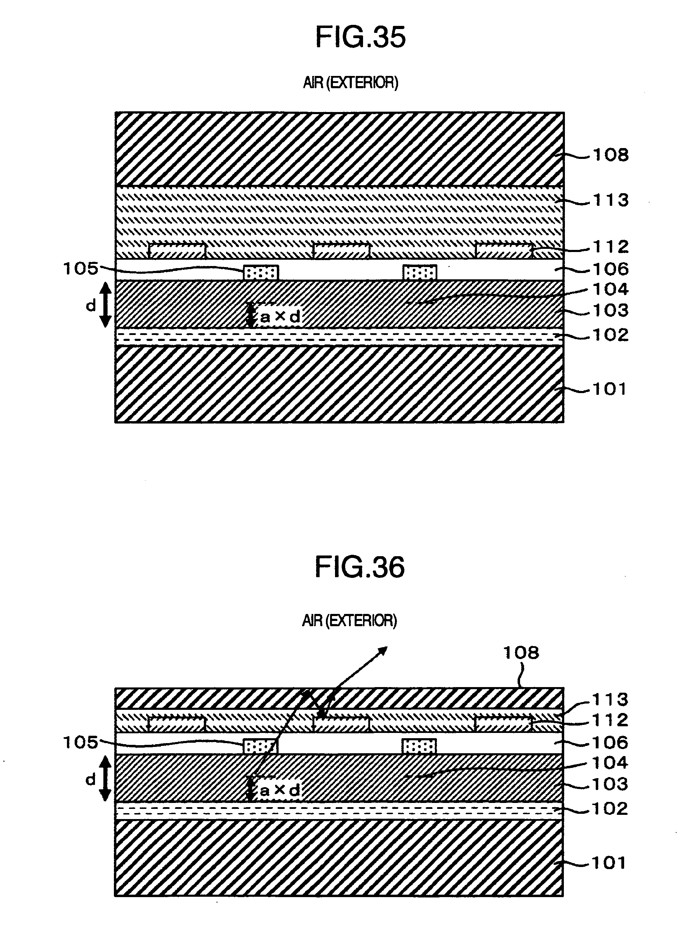

Fig. 34 is an exploded perspective view of an organic light emitting diode (OLED) of this embodiment. Fig. 35 is a cross-sectional view of the OLED of this embodiment. The OLED of this embodiment has a reflection-side substrate 101, aluminum reflection electrode 102, organic layer 103, transparent electrode 105, first transparent resin layer 106, diffuse reflection layer 112, second transparent resin layer 113 and output-side substrate 108. Although Figs. 34-35 are explanation diagrams of the top-emission type OLED, the bottom-emission type may alternatively be employed. On the aluminum reflection electrode 102 which is formed on the reflection-side substrate 101, the organic layer 103 composed of organic molecules is formed. The organic layer 103 involves a luminous point 104. The transparent electrode 105 is formed on the organic layer 103. On this transparent electrode 105, the first transparent resin layer 106 is disposed. The diffuse reflection layer 112 is adhered by the first transparent resin layer 106.

The diffuse reflection layer 112 has openings at those areas in which the reflection electrode 102 and transparent electrode 105 overlap each other in the normal line direction of the diffuse reflection layer 112. More specifically, in a case where one of the reflection electrode 102 and transparent electrode 105 is formed to have a solid plate shape whereas the other has a stripe shape, the openings of the diffuse reflection layer 112 become to have a stripe shape. Alternatively, in case both of the reflection electrode 102 and transparent electrode 105 have stripe shapes whose extension directions are at right angles to each other, the openings of the diffuse reflection layer 112 become a dot-like shape as shown in Fig. 34. This dot shape is desirable for the openings of the diffuse reflection layer 112. It is also desirable to arrange the openings of diffuse reflection layer 112 so that each is larger in size than the individual one of the areas in which the reflection electrode 102 and transparent electrode 105 overlap each other. This can be said because the use of this arrangement makes it possible to permit light with a large orientation angle to enter the output-side substrate 108.

The diffuse reflection layer 112 may typically be a white sheet with high reflectivity. An example of the white sheet is a polyethylene terephthalate (PET) film containing therein a great number of fine air bubbles created by foaming processes. A practical example of it is Lumirror E60L, E6SL or E60V, which is a foam polyester film manufactured by Toray Industries, Inc.. Other examples of the white sheet material include, but not limited to, a white resin/powder mixture which is composed of either an acrylate resin with its lateral chain carbon number of 4 or more or an acrylic resin with its side chain carbon number ranging from 1 to 3 and with a plasticizer, such as dibutyl phthalate (DBP) or the like, being added thereto, while causing the resin to contain therein a white powder of magnesium oxide, titanium oxide, barium titanate or else. Another example is a white rubber/powder mixture which is composed of chloroprene rubber, silicon rubber or fluorine-based rubber which contains a white powder of magnesium oxide, titanium oxide, barium titanate or else. A further example is a metallic reflective film having on its surface a fine concavo-convex configuration, such as that used as the diffuse reflection layer 112 of a reflection-type liquid crystal display (LCD) apparatus. In this case, a surface of the second transparent resin layer 113 on the output-side substrate 108 side is processed to have such concavoconvex shape; then, a film of high-reflective-index metal, such as aluminum or silver, is fabricated thereon by sputtering methods. The second transparent resin layer 113 covers the diffuse reflection layer 112; so, the second transparent resin layer 113 is contained in the openings of the diffuse reflection layer 112. The output-side substrate 108 is adhered by the second transparent resin layer 113. Note that the second transparent resin layer 113 is made of acrylic resin similar to that of the first transparent resin layer 106. Also note that the second transparent resin layer 113 may not necessarily be the same as the first transparent resin layer 106. But, by letting the material of the second transparent resin layer 113 be the same as that of the first transparent resin layer 106, the refractive indexes of these layers become the same as each other, resulting in the interfaces of the first transparent resin layer 106 and second transparent resin layer 113 becoming optically continuous. In other words, it becomes optically equivalent to the case where the interfaces of the first transparent resin layer 106 and second transparent resin layer 113 are absent.

Fig. 36 is a diagram for explanation of the principle of the thick-film waveguide mode reduction in this embodiment. The light that experienced total reflection at the interface between the output-side substrate 108 and ambient air performs diffuse reflection at the diffuse reflection layer 112. An incident angle at the interface between output-side substrate 108 and air of a part of the light that diffused and reflected in the diffuse reflection layer 112 becomes smaller than the total reflection critical angle; thus, the light is taken out or "released" to the air side. In cases where the diffuse reflection layer 112 is not provided, it has been difficult to release the light toward the air side because the light repeats total reflection with almost the same incident angle at the interface between the output-side substrate 108 and air and also at the reflection electrode 102.

The thin-film waveguide mode reduction in this embodiment is achieved by setting interference conditions appropriately. By setting θcof to ranging from about 35° to 50° in a similar way to that of the embodiment 1 shown in Fig. 4, it is possible to reduce the thin-film waveguide mode.

A further preferable device structure may be arranged by embedding the first conic solid-like transparent resin 107 used in the embodiment 1 in the first transparent resin layer 106. Regarding preferable correlations of the refractive index of first transparent resin layer 106, θcof, θpri and refractive index of first conic solid-like transparent resin 107, similar arrangements to those stated in the embodiment 1 are applicable. Note however that in this embodiment, the bottom face of the first conic solid-like transparent resin 107 is bonded by the diffuse reflection layer 112 to second transparent resin layer 113.

It should be noted that the thin-film waveguide mode reduction techniques and thick-film waveguide mode reduction schemes which have been stated in this description are practically implementable in various combinations.

**Claims**

1. An organic light emitting diode comprising an electrode (102), an organic layer (103) having a luminous point (104), a transparent electrode (105), an output-side substrate (108), and a light scattering layer (109) in contact with said output-side substrate, **characterized in that**
   said electrode, said organic layer, said transparent electrode and said output-side substrate are arranged in this order of sequence toward a direction of taking light out of said organic layer,

said light scattering layer is composed of a base material and particles (110) contained therein,
a refractive index of said particles is higher than a refractive index of said base material and a refractive index of said output-side substrate,
said luminous point emits light at an emission peak wavelength $\lambda$ (nm), and when a height from an interface between said electrode and said organic layer to said luminous point is given by "$a \times d$" (where d (nm) is a thickness of said organic layer, and 0<a<1), the height satisfies: $(2m\text{-}155/180)\lambda/4/n/\cos 35° \leq a \times d \leq (2m\text{-}155/180)\lambda/4/n/\cos 50°$ (where n is a refractive index of said organic layer, and m is an integer larger than or equal to 1).

2. The organic light emitting diode as recited in claim 1, **characterized in that** said light scattering layer is formed between said output-side substrate and said transparent electrode.

3. The organic light emitting diode as recited in claim 1, **characterized in that** said light scattering layer is formed on an opposite side to existence side of said transparent electrode with respect to said output-side substrate.

4. The organic light emitting diode as recited in any one of claims 1 to 3, **characterized in that** a first transparent resin layer (106) is disposed between said output-side substrate and said transparent electrode, and that a refractive index of said first transparent resin layer is the same as the refractive index of said output-side substrate.

5. The organic light emitting diode as recited in any one of claims 1 to 4, **characterized in that** said particles include specific particles with a grain size of from $0.5\mu$m to $6.0\mu$m, and that an average particle pitch of said specific particles ranges from 1.0 time to 6.0 times the grain size of said specific particles.

6. The organic light emitting diode as recited in any one of claims 1 to 4, **characterized in that** said particles include specific particles with a grain size of from $0.5\mu$m to $6.0\mu$m, and that an average particle pitch of said specific particles is greater than or equal to the grain size of said specific particles and less than or equal to $12\mu$m.

7. The organic light emitting diode as recited in any one of claims 1 to 4, **characterized in that** said particles include special particles with a grain size of $0.5\mu$m to $2.0\mu$m, and that an average particle pitch of said special particles is 1.0 time to 3.0 times the grain size of said special particles.

8. The organic light emitting diode as recited in any one of claims 1 to 4, **characterized in that** said particles include special particles with a grain size of $0.5\mu$m to $2.0\mu$m, and that an average particle pitch of said special particles is larger than or equal to the grain size of said special particles and less than or equal to $4.0\mu$m.

9. The organic light emitting diode as recited in any one of claims 1 to 3 and 5 to 8, **characterized in that** a first transparent resin layer (106) is placed between said transparent electrode (105) and said output-side substrate, that a first conic solid-like transparent resin (107) is formed within said first transparent resin layer, that a bottom face of said first conic solid-like transparent resin is adhered to said output-side substrate, and that said first conic solid-like transparent resin has its expansion from said first transparent resin layer toward said output-side substrate in a normal line direction of said output-side substrate.

10. The organic light emitting diode as recited in claim 9, **characterized in that** the height $a \times d$ satisfies: $(2m\text{-}155/180)\lambda/4/n/\cos 36° \leq a \times d \leq (2m\text{-}155/180)\lambda/4/n/\cos 48°$.

11. The organic light emitting diode as recited in claim 9 or 10, **characterized in that** a refractive index of said first transparent resin layer is more than or equal to 1.7 and less than or equal to 2.0, and that a refractive index of said first conic solid-like transparent resin is set to more than or equal to 1.5 and less than 1.7.

12. The organic light emitting diode as recited in any one of claims 9 to 11, **characterized in that** the refractive index of said first transparent resin layer divided by the refractive index of said output-side substrate is more than or equal to 1.13 and less than or equal to 1.33, and that the refractive index of said first conic solid-like transparent resin divided by the refractive index of said output-side substrate is more than or equal to 1 and less than 1.13.

13. The organic light emitting diode as recited in any one of claims 9 to 12, **characterized in that** the refractive index of said first conic solid-like transparent resin is more than or equal to 1.50 and less than or equal to 1.54, and that an expansion angle of said first conic solid-like transparent resin is more than or equal to 75° and less than or equal to 85°.

**14.** The organic light emitting diode as recited in any one of claims 9 to 12, **characterized in that** the refractive index of said first conic solid-like transparent resin is more than or equal to 1.55 and less than or equal to 1.64, and that an expansion angle of said first conic solid-like transparent resin is more than or equal to 70° and less than or equal to 80°.

**15.** The organic light emitting diode as recited in any one of claims 9 to 14, **characterized in that** said first conic solid-like transparent resin is dense-fill-disposed with respect to a surface of said output-side substrate.

# FIG.1

# FIG.2

AIR (EXTERIOR)

# FIG.3

# FIG.4

# FIG.5

# FIG.6

TOP PLAN VIEW OF SCATTERING LAYER

PARTICLE PITCH

PARTICLE PITCH  CROSS-SECTION  PARTICLE GRAIN SIZE

d=150nm
a×d=98nm

# FIG.7

Legend:
- GRAIN SIZE 0.5μm
- GRAIN SIZE 1μm
- GRAIN SIZE 2μm
- GRAIN SIZE 4μm
- GRAIN SIZE 6μm
- ✱ NO SCATTERING LAYER
- △ GRAIN SIZE 0.57μm (EXPERIMENTAL VALUE)
- ◇ GRAIN SIZE 1μm (EXPERIMENTAL VALUE)

Y-axis: THICK-FILM WAVEGUIDE MODE (a.u.)
X-axis: AVERAGE PARTICLE PITCH (μm)

# FIG.8

Legend:
- GRAIN SIZE 0.5μm
- GRAIN SIZE 1μm
- GRAIN SIZE 2μm
- GRAIN SIZE 6μm
- ✱ NO SCATTERING LAYER

Y-axis: THICK-FILM WAVEGUIDE MODE (a.u.)
X-axis: AVERAGE PARTICLE PITCH (μm)

# FIG.9

# FIG.10

AIR (EXTERIOR)

109
108
107
106
105
103
104
102
101

npri

APEX ANGLE IN CROSS-SECTION

$\theta$pri

nLPL

d

a × d

# FIG.11

108
107
106
105
103
102
101

a

b

c

## FIG.12

THIN-FILM WAVEGUIDE MODE

$\theta$pri(° )

— — $\theta$cof=0°
—·· $\theta$cof=26°
········ $\theta$cof=36°
—— $\theta$cof=42°
- - - $\theta$cof=48°
—·- $\theta$cof=50°

## FIG.13

THIN-FILM WAVEGUIDE MODE

$\theta$pri(° )

— — $\theta$cof=0°
—·· $\theta$cof=26°
········ $\theta$cof=36°
—— $\theta$cof=42°
- - - $\theta$cof=48°
—·- $\theta$cof=50°

## FIG.14

THIN-FILM WAVEGUIDE MODE

$\theta$ pri(° )

— — $\theta$ cof=0°
— ·· $\theta$ cof=26°
········· $\theta$ cof=36°
——— $\theta$ cof=42°
— — — $\theta$ cof=48°
— ·· — $\theta$ cof=50°

## FIG.15

THIN-FILM WAVEGUIDE MODE

$\theta$ pri(° )

— — $\theta$ cof=0°
— ·· $\theta$ cof=26°
········· $\theta$ cof=36°
——— $\theta$ cof=42°
— — — $\theta$ cof=48°
— ·· — $\theta$ cof=50°

# FIG.16

$\theta$pri(° )

- - $\theta$cof=0°
- ·· $\theta$cof=26°
········ $\theta$cof=36°
—— $\theta$cof=42°
- - - $\theta$cof=48°
- ·· $\theta$cof=50°

# FIG.17

$\theta$pri(° )

- - $\theta$cof=0°
- ·· $\theta$cof=26°
········ $\theta$cof=36°
—— $\theta$cof=42°
- - - $\theta$cof=48°
- ·· $\theta$cof=50°

## FIG.18

## FIG.19

## FIG.20

THIN-FILM WAVEGUIDE MODE

$\theta$ pri(° )

— — $\theta$ cof=0°
— ·· $\theta$ cof=26°
·········· $\theta$ cof=36°
——— $\theta$ cof=42°
— — — $\theta$ cof=48°
— ·· — $\theta$ cof=50°

## FIG.21

THIN-FILM WAVEGUIDE MODE

$\theta$ pri(° )

— — $\theta$ cof=0°
— ·· $\theta$ cof=26°
·········· $\theta$ cof=36°
——— $\theta$ cof=42°
— — — $\theta$ cof=48°
— ·· — $\theta$ cof=50°

## FIG.22

- – –  $\theta$ cof=0°
- – ··  $\theta$ cof=26°
- ········  $\theta$ cof=36°
- ——  $\theta$ cof=42°
- – – –  $\theta$ cof=48°
- – ··  $\theta$ cof=50°

THIN-FILM WAVEGUIDE MODE

$\theta$ pri(° )

## FIG.23

- – –  $\theta$ cof=0°
- – ··  $\theta$ cof=26°
- ········  $\theta$ cof=36°
- ——  $\theta$ cof=42°
- – – –  $\theta$ cof=48°
- – ··  $\theta$ cof=50°

THIN-FILM WAVEGUIDE MODE

$\theta$ pri(° )

# FIG.24

# FIG.25

# FIG.26

# FIG.27

# FIG.28

# FIG.29

# FIG.30

# FIG.31

AIR (EXTERIOR)

$\theta$pri2

111
108
107
106
105
103
104
102
101

npri

APEX ANGLE IN CROSS-SECTION

$\theta$pri

nLPL

d

a × d

# FIG.32

111
110
108
a
b

# FIG.33

Legend:
- —— nLPL=1.6、 $\theta$pri1=80°
- ...... nLPL=1.7、 $\theta$pri1=80°
- --- nLPL=1.8、 $\theta$pri1=75°
- — — nLPL=1.9、 $\theta$pri1=79°
- — · · nLPL=2.0、 $\theta$pri1=76°

Y-axis: THICK-FILM WAVEGUIDE MODE (a.u.)

X-axis: $\theta$pri2 (° )

# FIG.34

# FIG.35

AIR (EXTERIOR)

# FIG.36

AIR (EXTERIOR)

## FIG.37

EXTERNAL EXTRACTION MODE

THICK-FILM WAVEGUIDE MODE

OUTPUT-SIDE GLASS SUBSTRATE

TRANSPARENT RESIN LAYER

TRANSPARENT ELECTRODE

ORGANIC LAYER

REFLECTION ELECTRODE

REFLECTION-SIDE GLASS SUBSTRATE

THIN-FILM WAVEGUIDE MODE

## FIG.38

SEAL GLASS

REFLECTION ELECTRODE

ORGANIC LAYER

TRANSPARENT ELECTRODE

OUTPUT-SIDE GLASS SUBSTRATE

THIN-FILM WAVEGUIDE MODE

THICK-FILM WAVEGUIDE MODE

EXTERNAL EXTRACTION MODE

Europäisches
Patentamt

European
Patent Office

Office européen
des brevets

## EUROPEAN SEARCH REPORT

Application Number

EP 11 16 4715

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2009/028620 A1 (PANASONIC ELEC WORKS CO LTD [JP]; IDE NOBUHIRO [JP]; YAMANA MASAHITO []) 5 March 2009 (2009-03-05) * abstract * -& EP 2 190 265 A1 (PANASONIC ELEC WORKS CO LTD [JP]) 26 May 2010 (2010-05-26) * paragraphs [0018], [0020], [0031] - [0038]; figure 1; example 1; table 3 * | 1-15 | INV. H01L51/52 |
| Y | US 2009/051276 A1 (INOUE KATSUMI [JP] ET AL) 26 February 2009 (2009-02-26) * paragraphs [0096] - [0107], [0178] - [0199]; figure 5; table 2 * | 1-15 | |
| Y | JP 2003 086353 A (NISSAN CHEMICAL IND LTD) 20 March 2003 (2003-03-20) * paragraphs [0018] - [0027], [0038] - [0040]; figures 1,5; example 1 * | 9-15 | |

TECHNICAL FIELDS
SEARCHED       (IPC)

H01L
H05B

The present search report has been drawn up for all claims

| Place of search | Date of completion of the search | Examiner |
|---|---|---|
| The Hague | 8 September 2011 | Bakos, Tamás |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 11 16 4715

This annex lists the patent family members relating to the patent documents cited in the above-mentioned European search report.
The members are as contained in the European Patent Office EDP file on
The European Patent Office is in no way liable for these particulars which are merely given for the purpose of information.

08-09-2011

| Patent document cited in search report | | Publication date | Patent family member(s) | | Publication date |
|---|---|---|---|---|---|
| WO 2009028620 | A1 | 05-03-2009 | CN<br>EP<br>JP<br>KR<br>US | 101843172 A<br>2190265 A1<br>2009054493 A<br>20100063730 A<br>2011121267 A1 | 22-09-2010<br>26-05-2010<br>12-03-2009<br>11-06-2010<br>26-05-2011 |
| EP 2190265 | A1 | 26-05-2010 | CN<br>JP<br>WO<br>KR<br>US | 101843172 A<br>2009054493 A<br>2009028620 A1<br>20100063730 A<br>2011121267 A1 | 22-09-2010<br>12-03-2009<br>05-03-2009<br>11-06-2010<br>26-05-2011 |
| US 2009051276 | A1 | 26-02-2009 | JP | 2009070816 A | 02-04-2009 |
| JP 2003086353 | A | 20-03-2003 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004296423 A